# EUROPEAN PATENT SPECIFICATION

(11) **EP 2 833 705 B1**
(45) Date of publication and mention of the grant of the patent: **16.01.2019**
(21) Application number: 13767979.1
(22) Date of filing: 08.03.2013
(51) Int. Cl.: H05K 3/38, H05K 1/09, H05K 3/12, H05K 9/00, H05K 3/24

(54) **ELECTROCONDUCTIVE PATTERN, ELECTRIC CIRCUIT, ELECTROMAGNETIC WAVE SHIELD, AND METHOD FOR MANUFACTURING ELECTROCONDUCTIVE PATTERN**
ELEKTRISCH LEITENDES MUSTER, ELEKTRISCHE SCHALTUNG, ABSCHIRMUNG GEGEN ELEKTROMAGNETISCHE WELLEN UND VERFAHREN ZUR HERSTELLUNG DES ELEKTRISCH LEITENDEN MUSTERS
MOTIF ÉLECTROCONDUCTEUR, CIRCUIT ÉLECTRIQUE, BLINDAGE CONTRE LES ONDES ÉLECTROMAGNÉTIQUES ET PROCÉDÉ DE FABRICATION D'UN MOTIF ÉLECTROCONDUCTEUR

(30) Priority: 28.03.2012 JP 2012073765
(43) Date of publication of application: 04.02.2015
(73) Proprietor: DIC Corporation, Tokyo 174-8520 (JP)
(72) Inventor: MURAKAWA Akira, Takaishi-shi Osaka 592-0001 (JP); SHIRAKAMI Jun, Takaishi-shi Osaka 592-0001 (JP); FUJIKAWA Wataru, Takaishi-shi Osaka 592-0001 (JP); SAITOU Yukie, Takaishi-shi Osaka 592-0001 (JP)
(74) Representative: Adam, Holger
(86) International application number: PCT/JP2013/056486
(87) International publication number: WO 2013/146195

(56) References cited:
- WO-A1-2010/134536
- WO-A1-2011/078140
- JP-A- H01 259 595
- JP-A- H10 199 332
- JP-A- 2007 242 781
- JP-A- 2010 251 703
- US-A1- 2010 078 208
- US-A1- 2010 101 842
- US-A1- 2011 207 842

## Description

### Technical Field

The present invention relates to a conductive pattern that can be used in the production of an electromagnetic wave shield, an integrated circuit, an organic transistor, and the like.

### Background Art

Recently, with the realization of high performance, reduction in the sizes, and reduction in the thicknesses of electronic devices, the realization of high densities and reduction in the thicknesses of electronic circuits, integrated circuits, and the like that are used in the electronic devices has been strongly desired.

A known conductive pattern that can be used in the electronic circuits is produced by, for example, applying (printing) a conductive ink containing a conductive substance such as silver onto a surface of a substrate by a printing method, and conducting firing or the like, as required.

However, even when the conductive ink is applied directly onto a surface of a substrate, the conductive ink does not easily adhere to the surface of the substrate and thus easily separates from the substrate, which may result in, for example, disconnection of an electronic circuit or the like that is an end product.

Regarding the substrate, since a substrate composed of a polyimide resin or a polyethylene terephthalate resin has flexibility, such a substrate has attracted attention as a substrate that can be used in the production of flexible devices that can be bent.

However, in particular, the conductive ink does not easily adhere to such a substrate composed of a polyimide resin or the like, and thus the conductive ink easily separates from the substrate when the substrate is bent. As a result, disconnection of an electronic circuit or the like that is an end product may be caused.

A known method for solving the above problem is a method for forming a conductive pattern, the method including drawing, using a conductive ink by a predetermined method, a pattern on an ink-receiving base prepared by providing a latex layer on a surface of a substrate. It is known that an acrylic resin can be used as the latex layer (refer to, for example, PTL 1).

However, in some cases, the conductive pattern formed by the above method is still not enough in terms of adhesion between the latex layer and the conductive ink, which may cause disconnection and a decrease in the electrical conductivity due to the separation of a conductive substance contained in the conductive ink.

US 2010/0078208 A1 discloses a method of forming a wiring board comprising a step of forming a conductive pattern from a colloidal metal solution on a receptive layer formed on a substrate; however no bond is disclosed to be formed between a compound from the conductive layer and a compound from the receptive layer.

### Citation List

### Patent Literature

PTL 1: Japanese Unexamined Patent Application Publication No. 2009-49124

### Summary of Invention

### Technical Problem

An object to be achieved by the present invention is to provide a conductive pattern having such a level of adhesion that a conductive layer containing a conductive substance such as silver does not separate from a primer layer with time.

### Solution to Problem

As a result of studies in order to achieve the above object, the inventors of the present invention found that the object can be achieved by forming a bond between a substance contained in a conductive layer and a primer layer.

Specifically, the present invention relates to a conductive pattern including a conductive layer (A) containing a compound (a1) having a basic nitrogen atom-containing group and a conductive substance (a2); a primer layer (B) containing a compound (b1) having a functional group [X]; and a substrate layer (C), the conductive layer (A), the primer layer (B), and the substrate layer (C) being stacked, in which a bond is formed by reacting the basic nitrogen atom-containing group of the compound (a1) contained in the conductive layer (A) with the functional group [X] of the compound (b1) contained in the primer layer (B) .

### Advantageous Effects of Invention

The conductive pattern of the present invention has excellent adhesion between layers and can maintain an excellent electrical conductivity for a long time without causing disconnection or the like. Accordingly, the conductive pattern of the present invention can be used in a new field which is generally called a printed electronics field, for example, peripheral wiring that is included in an organic solar cell, an electronic book terminal, an organic electroluminescence (EL) device, an organic transistor, a flexible printed circuit board, radio-frequency identification (RFID) such as a non-contact IC card, or the like; wiring of an electromagnetic wave shield, an integrated circuit, an organic transistor of a plasma display; and the like.

### Description of Embodiments

A conductive pattern of the present invention is a conductive pattern including a conductive layer (A) containing a compound (a1) having a basic nitrogen atom-containing group and a conductive substance (a2); a primer layer (B) containing a compound (b1) having a functional group [X]; and a substrate layer (C), the conductive layer (A), the primer layer (B), and the substrate layer (C) being stacked, in which a bond is formed by reacting the basic nitrogen atom-containing group of the compound (a1) contained in the conductive layer (A) with the functional group [X] of the compound (b1) contained in the primer layer (B) .

The conductive pattern of the present invention includes at least a conductive layer (A), a primer layer (B), and a substrate layer (C).

First, the conductive layer (A) will be described.

The conductive layer (A) is a layer containing a compound (a1) having a basic nitrogen atom-containing group and a conductive substance (a2).

The conductive layer (A) contains the conductive substance (a2) as a main component, and contains the compound (a1) having the basic nitrogen atom-containing group as a dispersing agent of the conductive substance (a2) or the like. Some or all of the basic nitrogen atom-containing groups of the compound (a1) contained in the conductive layer (A) react with functional groups [X] of a compound (b1) contained in the primer layer (B) described below and form bonds.

The conductive layer (A) preferably contains the conductive substance (a2) in an amount in the range of 80% by mass to 99.9% by mass and the compound (a1) having a basic nitrogen atom-containing group in an amount in the range of 0.1% by mass to 20% by mass relative to the total of the conductive layer (A).

The conductive layer (A) may be a layer provided over an entire surface of the primer layer (B) or a layer provided on a part of a surface of the primer layer (B). Specifically, the conductive layer (A) disposed on a part of a surface of the primer layer (B) may be a thin-line-shaped layer drawn and formed on the surface of the primer layer (B). The thin-line-shaped layer is suitable in the case where the conductive pattern of the present invention is used in an electric circuit or the like.

The width (line width) of the thin-line-shaped layer (pattern) is about 0.01 to 200 µm and preferably about 0.01 to 150 µm from the viewpoint of, for example, realizing a high density of the conductive pattern.

The conductive layer (A) preferably has a thickness of 0.01 to 100 µm from the viewpoint of forming a conductive patter having a low resistance and an excellent electrical conductivity. In the case where the conductive layer (A) is a thin-line-shaped layer, the thickness (height) of the conductive layer (A) is preferably in the range of 0.1 to 50 µm.

The conductive layer (A) reacts with the functional group [X] of the compound (b1) contained in the primer layer (B) described below and forms a bond. The basic nitrogen atom-containing group of the compound (a1) is involved in this bonding.

Examples of the basic nitrogen atom-containing group include an imino group, a primary amino group, and a secondary amino group.

In the case where a compound having a plurality of basic nitrogen atom-containing groups in its molecule is used as the compound (a1), from the viewpoint of improving adhesion between the conductive layer (A) and the primer layer (B), one of the basic nitrogen atom-containing groups is preferably involved in the bond with the functional group [X] of the compound (b1) contained in the primer layer (B) described below when the conductive layer (A) is formed, and the other basic nitrogen atom-containing group preferably contributes to the interaction with the conductive substance (a2) such as silver in the conductive layer (A).

Next, the primer layer (B) included in the conductive pattern of the present invention will be described.

The primer layer (B) is a layer provided for the purpose of increasing adhesion between the conductive layer (A) and the substrate layer (C) described below.

Regarding the primer layer (B), a coating film (b) is formed by applying a composition (b1-1) containing a compound (b1) having a functional group [X] onto a surface of a substrate, and conducting drying or the like. The functional group [X] of the compound (b1), the functional group [X] being present in the coating film (b), reacts with the basic nitrogen atom-containing group of the compound (a1) contained in the conductive layer (A) to thereby form a bond.

When a fluid (A1) containing the compound (a1) having the basic nitrogen atom-containing group, the conductive substance (a2), etc. comes in contact with a surface of the coating film (b), the coating film (b) absorbs a solvent contained in the fluid (A1) and carries the conductive substance (a2), etc. contained in the fluid (A1) on the surface thereof.

Subsequently, by performing a step of heating or the like, the basic nitrogen atom-containing group of the compound (a1) and the functional group [X] of the compound (b1) contained in the coating film (b) are reacted with each other to form a bond. Thus, a stacked structure including the conductive layer (A) and the primer layer (B) is formed.

As a result, it is possible to obtain a conductive pattern having such a level of excellent adhesion that separation at the interface between the conductive layer (A) and the primer layer (B) with time does not occur.

The coating film (b), which is a precursor of the primer layer (B), is formed by applying the composition (b1-1) containing the compound (b1) having the functional group [X] onto a surface of a substrate, and conducting drying or the like. The compound (b1) contained in the coating film (b) has the functional group [X] that reacts with the basic nitrogen atom-containing group of the compound (a1) contained in the conductive layer (A).

Examples of the functional group [X] include a keto group, an epoxy group, a carboxylic acid group, a carboxylic anhydride group, an alkylolamide group, an isocyanate group, a vinyl group, an alkyl halide group, an acryloyl group, a cyanamide group, a urea bond, and an acyl halide group. The keto group refers to a carbonyl group derived from a ketone. The isocyanate group may be blocked by a blocking agent from the viewpoint of preventing a reaction from occurring at room temperature.

In particular, at least one selected from the group consisting of a keto group, an epoxy group, an acid group, an alkylolamide group, and an isocyanate group is preferably used as the functional group [X] from the viewpoint of preventing byproducts such as a halogen, an acid, and an amine from generating when the functional group [X] reacts with the basic nitrogen atom-containing group of the compound (a1).

The functional group [X] is preferably present in the range of 50 to 5,000 mmol/kg, more preferably in the range of 100 to 3,000 mmol/kg, and still more preferably in the range of 100 to 1,000 mmol/kg relative to the total of the coating film (b) from the viewpoint of further improving adhesion.

The primer layer (B) formed through the heating step may have some of the functional groups [X] that remain without reacting with the basic nitrogen atom-containing group.

The primer layer (B) may be provided on a part of a surface or an entire surface of the substrate layer (C). The primer layer (B) may be provided on one surface or both surfaces of the substrate. For example, it is possible to use the conductive pattern including the primer layer (B) provided over an entire surface of the substrate layer (C), and the conductive layer (A) provided only on a necessary part of the primer layer (B). Alternatively, the conductive pattern may include the primer layer (B) provided only on a part of a surface of the substrate layer (C) where the conductive layer (A) is provided.

The primer layer (B) preferably has a thickness of about 0.01 to 300 µm and more preferably 0.01 to 20 µm from the viewpoint that, in the case where a flexible substrate that can be substantially bent is used, the flexibility of the substrate is maintained, though the thickness varies depending on the use or the like of the conductive pattern of the present invention.

Next, the substrate layer (C) included in the conductive pattern of the present invention will be described.

The substrate layer (C) included in the conductive pattern of the present invention is constituted by a substrate.

Examples of the substrate that can be used include insulating substrates composed of a polyimide resin, a polyamide-imide resin, a polyamide resin, a polyethylene terephthalate resin, a polyethylene naphthalate resin, a polycarbonate resin, an acrylonitrile-butadiene-styrene (ABS) resin, an acrylic rein such as polymethyl (meth)acrylate, a polyvinylidene fluoride resin, a polyvinyl chloride resin, a polyvinylidene chloride resin, a polyvinyl alcohol resin, a polyethylene resin, a polypropylene resin, a urethane resin, a cellulose nanofiber, silicon, a ceramic, glass, or the like; and porous insulating substrates composed of any of these materials.

Alternatively, for example, a base composed of a synthetic fiber such as a polyester fiber, a polyamide fiber, or an aramid fiber, or a natural fiber such as cotton or hemp may be used as the substrate. The fibers may be subjected to a treatment in advance.

As for the substrate, it is preferable to use a substrate composed of a polyimide resin, polyethylene terephthalate, polyethylene naphthalate, glass, a cellulose nanofiber, or the like, which is usually often used as a substrate for forming a conductive pattern of an electric circuit or the like.

A substrate that is relatively flexible and, for example, that can be bent is preferably used as the substrate from the viewpoint of providing the conductive pattern with flexibility and obtaining a final product that can be bent. Specifically, a film- or sheet-like substrate formed by performing uniaxial stretching or the like is preferably used.

For example, a polyethylene terephthalate film, a polyimide film, a polyethylene naphthalate film, or the like is preferably used as the film- or sheet-like substrate.

A substrate having a thickness of about 1 to 200 µm is preferably used as the substrate from the viewpoint of realizing a reduction in the weights and a reduction in the thicknesses of the conductive pattern and the final product obtained by using the conductive pattern.

A method for producing a conductive pattern of the present invention will now be described.

The conductive pattern of the present invention can be produced by applying a composition (b1-1) containing the compound (b1) having the functional group [X] onto a part of a surface or an entire surface of a substrate, and, as required, conducting drying or the like to form a coating film (b), which is a precursor of the primer layer (B); and applying a fluid (A1) containing the compound (a1) having the basic nitrogen atom-containing group and the conductive substance (a2) onto a part of a surface or an entire surface of the coating film (b) and then conducting a heating step such as firing.

First, a description will be made of a method for forming a coating film (b) by applying a composition (b1-1) onto a part of a surface or an entire surface of the substrate.

The coating film (b) can be formed by a method including applying the composition (b1-1) onto the substrate, and removing a solvent such as an aqueous medium or an organic solvent which is contained in the composition (b1-1).

Examples of the method for applying the composition (b1-1) onto the surface of the substrate include a gravure method, a coating method, a screen method, a roller method, a rotary method, a spray method, a spin coater method, and an ink-jet method.

A typical example of the method for removing the solvent contained in the composition (b1-1) is a method in which drying is performed with a dryer to volatilize the solvent. The drying temperature is set to a range in which the solvent can be volatilized and the substrate is not adversely affected.

From the viewpoint of providing excellent adhesion and electrical conductivity, the amount of composition (b1-1) applied onto the substrate is determined so that the thickness of the coating film (b) is preferably in the range of 0.01 to 300 µm and more preferably in the range of 0.05 to 20 µm.

The coating film (b) prepared by the above method contains the compound (b1) having the functional group [X] that can react with a basic nitrogen atom-containing group of the compound (a1) having the basic nitrogen atom-containing group, the compound (a1) being contained in the fluid (A1). The reaction may proceed when the compound (a1) having the basic nitrogen atom-containing group adheres to a surface of the coating film (b). However, the reaction usually proceeds through a heating step such as firing.

The thickness of the coating film (b) prepared by the above method is preferably determined so that the thickness of the primer layer (B) included in the conductive pattern that is an end product becomes in the range of 0.01 to 300 µm.

The coating film (b) is a swelling-type receiving layer that is moderately dissolved by a solvent contained in the fluid (A1) and absorbs the solvent, and that can fix the conductive substance (a2) such as a metal contained in the fluid (A1) with a high accuracy. Thus, the coating film (b) can contribute to the preparation of a bleeding-free conductive pattern. Furthermore, by using the coating film (b), a transparent primer layer can be formed as compared with a known porous receiving layer.

A composition containing the compound (b1) having the functional group [X] and a solvent can be used as the composition (b1-1) that forms the coating film (b) and finally forms the primer layer (B).

For example, a resin having a functional group [X] can be used as the compound (b1) having the functional group [X].

Specific examples of the resin having the functional group [X] and capable of being used include urethane resins (x1) having the functional group [X], vinyl resins (x2) having the functional group [X], urethane-vinyl composite resins (x3) having the functional group [X], epoxy resins having the functional group [X], imide resins having the functional group [X], amide resins having the functional group [X], melamine resins having the functional group [X], phenolic resins having the functional group [X], polyvinyl alcohols having the functional group [X], and polyvinylpyrrolidones having the functional group [X]. Among these resins, at least one selected from the group consisting of urethane resins (x1) having the functional group [X], vinyl resins (x2) having the functional group [X], and urethane-vinyl composite resins (x3) having the functional group [X] is preferably used.

As the compound (b1), at least one resin (x-1) selected from the group consisting of urethane resins having a polyether structure, urethane resins having a polycarbonate structure, and urethane resins having an aliphatic polyester structure, all of which are the urethane resins (x1), acrylic resins, which are the vinyl resins (x2), and urethane-acrylic composite resins, which are the urethane-vinyl composite reins (x3) is preferably used, and a urethane-acrylic composite resin is more preferably used from the viewpoint of further improving adhesion and the like.

The urethane resin (x1) and the vinyl resin (x2) may be used in combination as the compound (b1). In the case where the resins are used in this combination, the urethane resin (x1) and the vinyl resin (x2) are preferably contained in the range of [(x1)/(x2)] = 90/10 to 10/90, and are suitably used in the range of 70/30 to 10/90.

As the composition (b1-1), a composition containing a resin serving as the compound (b1) in an amount of 10% to 70% by mass relative to the total of the composition (b1-1) is preferably used from the viewpoint of maintaining the ease of coating, and a composition containing a resin serving as the compound (b1) in an amount of 10% to 50% by mass are more preferably used.

Examples of the solvent that can be used in the composition (b1-1) include various organic solvents and aqueous media.

Examples of the organic solvents that can be used include toluene, ethyl acetate, and methyl ethyl ketone. Examples of the aqueous media include water, organic solvents miscible with water, and mixtures thereof.

Examples of the organic solvents miscible with water include alcohols such as methanol, ethanol, n-propyl alcohol, isopropyl alcohol, ethyl carbitol, ethyl cellosolve, and butyl cellosolve; ketones such as acetone and methyl ethyl ketone; polyalkylene glycols such as ethylene glycol, diethylene glycol, and propylene glycol; alkyl ethers of polyalkylene glycols; and lactams such as N-methyl-2-pyrrolidone.

In the present invention, only water may be used, a mixture of water and an organic solvent miscible with water may be used, or only an organic solvent miscible with water may be used. From the viewpoint of safety and the load on the environment, only water or a mixture of water and an organic solvent miscible with water is preferable. Only water is particularly preferable.

In the case where an aqueous medium is used as the solvent, a resin having a hydrophilic group is preferably used as the compound (b1) from the viewpoint of improving water dispersion stability and storage stability of the composition (b1-1).

Examples of the hydrophilic group include an anionic group, a cationic group, and a nonionic group. An anionic group is more preferable.

Examples of the anionic group that can be used include a carboxyl group, a carboxylate group, a sulfonic acid group, and a sulfonate group. Among these, carboxylate groups or sulfonate groups, some or all of which are neutralized by a basic compound are preferably used from the viewpoint of providing good water dispersibility to the resin.

Examples of the basic compound that can be used for neutralizing the anionic groups include ammonia; organic amines such as triethylamine, pyridine, and morpholine; alkanolamines such as monoethanolamine; and metal basic compounds containing, for example, sodium, potassium, lithium, or calcium. In the case where a conductive pattern is formed, ammonia, the organic amines, or the alkanolamines are preferably used as the basic compound because the metal basic compounds may degrade electrical conduction properties.

In the case where the carboxylate group or the sulfonate group is used as the anionic group, the carboxylate group or the sulfonate group is preferably present in the range of 50 to 2,000 mmol/kg relative to the total of the resin from the viewpoint of providing good water dispersion stability to the resin.

Examples of the cationic group that can be used include tertiary amino groups.

Examples of an acid that can be used for neutralizing some or all of the tertiary amino groups include organic acids such as acetic acid, propionic acid, lactic acid, and maleic acid; sulfonic acids such as sulfonic acid and methanesulfonic acid; and inorganic acids such as hydrochloric acid, sulfuric acid, orthophosphoric acid, and orthophosphorous acid. In the case where a conductive pattern or the like is formed, acetic acid, propionic acid, lactic acid, maleic acid, or the like is preferably used because chlorine or sulfur may degrade electrical conduction properties, etc.

Examples of the nonionic group that can be used include polyoxyalkylene groups such as a polyoxyethylene group, a polyoxypropylene group, a polyoxybutylene group, a poly(oxyethylene-oxypropylene) group, and a polyoxyethylene-polyoxypropylene group. Among these, polyoxyalkylene groups having an oxyethylene unit are preferably used from the viewpoint of further improving hydrophilicity.

Urethane resins prepared by reacting a polyol, a polyisocyanate, and, as required, a chain extender with each other can be used as the urethane resin (x1) that can be used as the compound (b1) contained in the composition (b1-1). Among these, from the viewpoint of further improving adhesion, a urethane resin having a polyether structure, a urethane resin having a polycarbonate structure, or a urethane resin having an aliphatic polyester structure is preferably used.

The polyether structure, the polycarbonate structure, and the aliphatic polyester structure are preferably structures derived from the polyol used in the production of the urethane resins. Specifically, regarding the urethane resin having a polyether structure, a polyol containing a polyether polyol described below is preferably used as the polyol used in the production of the urethane resin. Regarding the urethane resin having a polycarbonate structure, a polyol containing a polycarbonate polyol described below is preferably used as the polyol. Regarding the urethane resin having an aliphatic polyester structure, a polyol containing an aliphatic polyester polyol described below is preferably used as the polyol.

Examples of the polyols that can be used in the production of the urethane resin (x1) include polyether polyols, polycarbonate polyols, and aliphatic polyester polyols, as described above. If necessary, other polyols may be used in combination as the polyol.

Examples of the polyether polyols that can be used include polyether polyols obtained by addition polymerization of an alkylene oxide using, as an initiator, at least one compound having two or more active hydrogen atoms.

Examples of the initiator that can be used include ethylene glycol, diethylene glycol, triethylene glycol, propylene glycol, trimethylene glycol, 1,3-butanediol, 1,4-butanediol, 1,6-hexanediol, neopentyl glycol, glycerol, trimethylolethane, and trimethylolpropane.

Examples of the alkylene oxide that can be used include ethylene oxide, propylene oxide, butylene oxide, styrene oxide, epichlorohydrin, and tetrahydrofuran.

Examples of the polycarbonate polyols that can be used include polycarbonate polyols obtained by a reaction between a carbonic acid ester and a polyol, and polycarbonate polyols obtained by a reaction between phosgene and bisphenol A or the like.

Examples of the carbonic acid ester that can be used include methyl carbonate, dimethyl carbonate, ethyl carbonate, diethyl carbonate, cyclocarbonate, and diphenyl carbonate.

Examples of the polyol that can react with the carbonic acid ester include dihydroxy compounds having a relatively low molecular weight, such as ethylene glycol, diethylene glycol, triethylene glycol, 1,2-propylene glycol, 1,3-propylene glycol, dipropylene glycol, 1,4-butanediol, 1,3-butanediol, 1,2-butanediol, 2,3-butanediol, 1,5-pentanediol, 1,5-hexanediol, 2,5-hexanediol, 1,6-hexanediol, 1,7-heptanediol, 1,8-octanediol, 1,9-nonanediol, 1,10-decanediol, 1,11-undecanediol, 1,12-dodecanediol, 3-methyl-1,5-pentanediol, 2-ethyl-1,3-hexanediol, 2-methyl-1,3-propanediol, 2-methyl-1,8-octanediol, 2-butyl-2-ethylpropanediol, neopentyl glycol, hydroquinone, resorcin, bisphenol A, bisphenol F, and 4,4'-biphenol.

Examples of the aliphatic polyester polyols that can be used include aliphatic polyester polyols obtained by an esterification reaction between a polyol having a low molecular weight and a polycarboxylic acid; aliphatic polyesters obtained by a ring-opening polymerization reaction of a cyclic ester compound such as ε-caprolactone or γ-butyrolactone; and copolymerized polyesters of these.

Examples of the polyol having a low molecular weight and capable of being used in the production of the polyester polyols include ethylene glycol, 1,2-propanediol, 1,3-butanediol, 1,4-butanediol, 1,6-hexanediol, 3-methyl-1,5-pentanediol, neopentyl glycol, diethylene glycol, dipropylene glycol, glycerol, trimethylolpropane, and 1,4-cyclohexanedimethanol. These may be used alone or in combination of two or more polyols. Ethylene glycol, 1,2-propanediol, 1,3-butanediol, or 1,4-butanediol and 3-methyl-1,5-pentanediol or neopentyl glycol are preferably used in combination.

Examples of the polycarboxylic acid that can be used include succinic acid, adipic acid, sebacic acid, dodecanedicarboxylic acid, azelaic acid, anhydrides thereof, and esterified products thereof. Aliphatic polycarboxylic acids such as adipic acid are preferably used.

As the polyether polyols, polycarbonate polyols, and aliphatic polyester polyols, polyols having a number-average molecular weight in the range of 500 to 4,000 are preferably used and polyols having a number-average molecular weight in the range of 500 to 2,000 are more preferably used.

As for the polyols that can be used in the production of the urethane resin (x1), besides the polyols described above, other polyols may be used in combination, as required.

Examples of the other polyols include ethylene glycol, 1,2-propanediol, 1,3-butanediol, 1,4-butanediol, 3-methyl-1,5-pentanediol, 1,6-hexanediol, 1,4-cyclohexanedimethanol, neopentyl glycol, diethylene glycol, dipropylene glycol, glycerol, trimethylolpropane, acrylic polyols obtained by introducing hydroxyl groups into acrylic copolymers, polybutadiene polyols, hydrogenated polybutadiene polyols, and partially saponified products of ethylene-vinyl acetate copolymers. These polyols can be appropriately used as required.

In the case where a urethane resin having a hydrophilic group is used as the urethane resin (x1), polyols having a hydrophilic group are preferably used as the other polyols.

Examples of the polyols having a hydrophilic group and capable of being used include polyols having a carboxyl group, such as 2,2-dimethylolpropionic acid, 2,2-dimethylolbutanoic acid, and 2,2-dimethylolvaleric acid; and polyols having a sulfonic acid group, such as 5-sulfoisophthalic acid, sulfoterephthalic acid, 4-sulfophthalic acid, and 5-[4-sulfophenoxy]isophthalic acid. It is also possible to use, as the polyol having a hydrophilic group, for example, polyester polyols having a hydrophilic group, the polyester polyols being obtained by reacting the above low-molecular-weight polyol having a hydrophilic group with a polycarboxylic acid such as adipic acid.

The polyol having a hydrophilic group is preferably used in an amount in the range of 0.1% to 10% by mass relative to the total amount of polyol used in the production of the urethane resin (x1).

Examples of the polyisocyanate that can be used in the reaction with the polyol include polyisocyanates having an aromatic structure, such as 4,4'-diphenylmethane diisocyanate, 2,4'-diphenylmethane diisocyanate, carbodiimide-modified diphenylmethane diisocyanate, crude diphenylmethane diisocyanate, phenylene diisocyanate, tolylene diisocyanate, and naphthalene diisocyanate; aliphatic polyisocyanates and polyisocyanates having an alicyclic structure, such as hexamethylene diisocyanate, lysine diisocyanate, cyclohexane diisocyanate, isophorone diisocyanate, dicyclohexylmethane diisocyanate, xylylene diisocyanate, and tetramethylxylylene diisocyanate. Among these, polyisocyanates having an alicyclic structure are preferably used.

Examples of the chain extender that can be used in the production of the urethane resin include polyamines, hydrazine compounds, and active hydrogen atom-containing compounds.

Examples of the polyamines that can be used include diamines such as ethylenediamine, 1,2-propanediamine, 1,6-hexamethylenediamine, piperazine, 2,5-dimethylpiperazine, isophoronediamine, 4,4'-dicyclohexylmethanediamine, 3,3'-dimethyl-4,4'-dicyclohexylmethanediamine, and 1,4-cyclohexanediamine; N-hydroxymethylaminoethylamine, N-hydroxyethylaminoethylamine, N-hydroxypropylaminopropylamine, N-ethylaminoethylamine, N-methylaminopropylamine, diethylenetriamine, dipropylenetriamine, and triethylenetetramine. Among these, ethylenediamine is preferably used.

Examples of the hydrazine compounds that can be used include hydrazine, N,N'-dimethylhydrazine, 1,6-hexamethylenebishydrazine, succinic acid dihydrazide, adipic acid dihydrazide, glutaric acid dihydrazide, sebacic acid dihydrazide, isophthalic acid dihydrazide, β-semicarbazide propionic acid hydrazide, 3-semicarbazide-propyl-carbazate, and semicarbazide-3-semicarbazidemethyl-3,5,5-trimethylcyclohexane.

Examples of the active hydrogen atom-containing compounds that can be used include glycols such as ethylene glycol, diethylene glycol, triethylene glycol, propylene glycol, 1,3-propanediol, 1,3-butanediol, 1,4-butanediol, hexamethylene glycol, saccharose, methylene glycol, glycerol, and sorbitol; phenols such as bisphenol A, 4,4'-dihydroxydiphenyl, 4,4'-dihydroxydiphenyl ether, 4,4'-dihydroxydiphenyl sulfone, hydrogenated bisphenol A, and hydroquinone; and water.

The chain extender is used so that, for example, an equivalent ratio of amino groups in the polyamine to isocyanate groups is preferably 1.9 or less (equivalent ratio) and more preferably in the range of 0.3 to 1 (equivalent ratio).

The urethane resin (x1) can be produced by, for example, reacting the polyol, the polyisocyanate, and, as required, the chain extender with each other in the absence of a solvent or in the presence of an organic solvent by a known method.

The reaction between the polyol and the polyisocyanate can be conducted at a reaction temperature of preferably 50°C to 120°C and more preferably 80°C to 100°C while sufficient care is taken with sudden heat generation, foaming, etc. in consideration of safety. The polyol and the polyisocyanate are mixed at one time or one of the polyol and the polyisocyanate is successively supplied to the other by, for example, dropping, and the reaction is conducted for about 1 to 15 hours.

An aqueous dispersion of the urethane resin (x1), the aqueous dispersion being capable of being used as the composition (b1-1), can be produced as follows. The polyol, the polyisocyanate, and, as required, a chain extender are reacted with each other by the method described above to produce a urethane resin (x1). Some or all of the hydrophilic groups, such as anionic groups, of the urethane resin (x1) are neutralized as required, and the resulting urethane resin (x1) is then mixed with an aqueous medium used as a solvent of the composition (b1-1).

More specifically, the polyol and the polyisocyanate are reacted with each other by the method described above to produce a urethane prepolymer having an isocyanate group at an end thereof. Some or all of the hydrophilic groups, such as anionic groups, of the urethane prepolymer are neutralized as required, and the resulting prepolymer is then mixed with the aqueous medium. If necessary, chain extension is conducted with the chain extender. Thus, a urethane resin (x1) aqueous dispersion in which the urethane resin (x1) that can be used as the composition (b1-1) is dispersed or dissolved in the aqueous medium can be produced.

The reaction between the polyisocyanate and the polyol is preferably conducted so that, for example, an equivalent ratio [isocyanate group/hydroxyl group] of isocyanate groups in the polyisocyanate to hydroxyl groups in the polyol is in the range of 0.9 to 2.

In producing the urethane resin (x1), as described above, an organic solvent may be used as a solvent.

Examples of the organic solvent include ketones such as acetone and methyl ethyl ketone; ethers such as tetrahydrofuran and dioxane; acetic acid esters such as ethyl acetate and butyl acetate; nitriles such as acetonitrile; and amides such as dimethylformamide and N-methylpyrrolidone. These organic solvents may be used alone or in combination of two or more organic solvents.

The organic solvent is preferably removed by, for example, distillation after the urethane resin (x1) is produced. However, in the case where a composition containing the urethane resin (x1) and an organic solvent is used as the composition (b1-1), an organic solvent used in the production of the urethane resin (x1) may be used as the solvent of the composition (b1-1).

As the urethane resin (x1), a urethane resin having a weight-average molecular weight of 5,000 to 500,000 is preferably used, and a urethane resin having a weight-average molecular weight of 20,000 to 100,000 is more preferably used from the viewpoint of forming a conductive pattern having excellent adhesion and excellent electrical conductivity.

An example of a method for introducing, into the urethane resin (x1), a functional group [X] that can react with a basic nitrogen atom-containing group of the compound (a1) having the basic nitrogen atom-containing group and that can form a bond is a method in which a polyol having a functional group [X] is used as a polyol that can be used in the production of the urethane resin (x1). For example, in the case where a keto group is introduced as the functional group [X], a method in which a polyol having a keto group is used as the polyol may be employed.

In the case where an epoxy group is introduced as the functional group [X], a method may be employed in which a polyol having an epoxy group is used as a polyol used in the production of the urethane resin (x1).

In the case where a carboxylic acid group is introduced as the functional group [X], a method may be employed in which the polyol having a carboxyl group is used as a polyol used in the production of the urethane resin (x1).

In the case where an isocyanate group or a blocked isocyanate group is introduced as the functional group [X], for example, the following methods may be employed. In producing the urethane resin (x1) by a reaction between the polyol and the polyisocyanate, the reaction may be controlled so that isocyanate groups remain. Alternatively, the isocyanate groups may be blocked by using a blocking agent such as methyl ethyl ketone oxime.

The urethane resin (x1) preferably has the functional group [X] in an amount in the range of 50 to 5,000 mmol/kg relative to the total of the urethane resin (x1).

The urethane resin (x1) may have a cross-linkable functional group such as an alkoxysilyl group, a silanol group, a hydroxyl group, or an amino group besides the functional group [X].

The cross-linkable functional group is preferable from the viewpoint that a pattern (conductive layer (A)) having excellent durability is formed by forming a cross-linked structure in the primer layer (B) that carries the fluid (A1).

The alkoxysilyl group and the silanol group can be introduced into the urethane resin (x1) by using γ-aminopropyltriethoxysilane or the like in producing the urethane resin (x1).

As the vinyl resin (x2) that can be used as the compound (b1) contained in the composition (b1-1), a polymer of a monomer having a polymerizable unsaturated double bond can be used. Specific examples thereof that can be used include polyethylene, polypropylene, polybutadiene, ethylene-propylene copolymers, natural rubber, synthetic isopropylene rubber, ethylene-vinyl acetate copolymers, and acrylic resins. Acrylic resins are preferably used from the viewpoint that a functional group [X] is easily introduced.

Polymers and copolymers obtained by polymerizing (meth)acrylic monomers can be used as the acrylic resins. Note that the term "(meth)acrylic monomer" refers to at least one of an acrylic monomer and a methacrylic monomer. Similarly, the term "(meth)acrylic acid" refers to at least one of acrylic acid and methacrylic acid. The term "(meth)acrylate" refers to at least one of acrylate and methacrylate.

The acrylic resins can be produced by, for example, polymerizing (meth)acrylic monomers described below.

Examples of the (meth)acrylic monomer that can be used include (meth)acrylic acid esters such as methyl (meth)acrylate, ethyl (meth)acrylate, n-butyl (meth)acrylate, i-butyl (meth)acrylate, t-butyl (meth)acrylate, 2-ethylhexyl (meth)acrylate, hexyl (meth)acrylate, cyclohexyl (meth)acrylate, octyl (meth)acrylate, nonyl (meth)acrylate, dodecyl (meth)acrylate, stearyl (meth)acrylate, isobornyl (meth)acrylate, norbornyl (meth)acrylate, tricyclodecanyl (meth)acrylate, adamantyl (meth)acrylate, dicyclopentanyl (meth)acrylate, phenyl (meth)acrylate, and benzyl (meth)acrylate; (meth)acrylic acid alkyl esters such as 2,2,2-trifluoroethyl (meth)acrylate, 2,2,3,3-pentafluoropropyl (meth)acrylate, perfluorocyclohexyl (meth)acrylate, 2,2,3,3-tetrafluoropropyl (meth)acrylate, β-(perfluorohexyl)ethyl (meth)acrylate, (poly)ethylene glycol di(meth)acrylate, (poly)propylene glycol di(meth)acrylate, (poly)butylene glycol di(meth)acrylate, (poly)neopentyl glycol di(meth)acrylate, and N,N'-methylenebis(meth)acrylamide; and tricyclodecane dimethanol diacrylate.

An example of a method for introducing, into the vinyl resin (x2), a functional group [X] that can react with a basic nitrogen atom-containing group of the compound (a1) having the basic nitrogen atom-containing group and that can form a bond is a method in which a monomer having the functional group [X] is used as the monomer having a polymerizable unsaturated double bond. For example, in the case where a keto group is introduced as the functional group [X], a method in which a monomer having a keto group, such as diacetone acrylamide, is used may be employed.

In the case where an acetoacetoxy group is introduced as the functional group [X], for example, a method using 2-acetoacetoxyethyl (meth)acrylate may be employed.

In the case where an epoxy group is introduced as the functional group [X], for example, a method using glycidyl (meth)acrylate or allyl glycidyl (meth)acrylate may be employed.

In the case where an acid group or an acid anhydride group is introduced as the functional group [X], for example, a method may be employed in which a monomer having a carboxyl group or an anhydride thereof, such as acrylic acid, methacrylic acid, β-carboxyethyl (meth)acrylate, 2-(meth)acryloyl propionic acid, crotonic acid, itaconic acid, maleic acid, fumaric acid, itaconic acid-half ester, maleic acid-half ester, maleic anhydride, itaconic anhydride, citraconic anhydride, β-(meth)acryloyloxyethyl hydrogen succinate, citraconic acid, citraconic acid-half ester, or citraconic anhydride is used.

In the case where an isocyanate group or a blocked isocyanate group is introduced as the functional group [X], for example, a method using a monomer having an isocyanate group or a blocked product thereof, such as (meth)acryloyl isocyanate, (meth)acryloyl isocyanate ethyl, a phenol adduct thereof, or a methyl ethyl ketoxime adduct thereof may be employed.

In the case where an N-alkylol group is introduced as the functional group [X], a method using N-methylol(meth)acrylamide, N-methoxymethyl(meth)acrylamide, N-ethoxymethyl(meth)acrylamide, N-propoxymethyl(meth)acrylamide, N-isopropoxymethyl(meth)acrylamide, N-n-butoxymethyl(meth)acrylamide, N-isobutoxymethyl(meth)acrylamide, N-pentoxymethyl(meth)acrylamide, N-ethanol acrylamide, N-propanol acrylamide, or the like may be employed.

Acrylic resins having a cross-linkable functional group such as an amide group, a hydroxyl group, an amino group, a silyl group, an aziridinyl group, an oxazoline group, or a cyclopentenyl group, as required, may be used as the acrylic resins.

Examples of monomers that can be used in introducing the cross-linkable functional group into the vinyl resin (x2) such as the acrylic resin include (meth)acrylamide; vinyl monomers having a hydroxyl group, such as 2-hydroxyethyl (meth)acrylate, 2-hydroxypropyl (meth)acrylate, 2-hydroxybutyl (meth)acrylate, 4-hydroxybutyl (meth)acrylate, 6-hydroxyhexyl (meth)acrylate, (4-hydroxymethylcyclohexyl)methyl (meth)acrylate, glycerol (meth)acrylate, polyethylene glycol (meth)acrylate, and N-hydroxyethyl(meth)acrylamide; vinyl monomers having an amino group, such as aminoethyl (meth)acrylate, dimethylaminoethyl (meth)acrylate, N-monoalkylaminoalkyl (meth)acrylate, and N,N-dialkylaminoalkyl (meth)acrylate; polymerizable monomers having a silyl group, such as vinyltrichlorosilane, vinyltrimethoxysilane, vinyltriethoxysilane, vinyltris(β-methoxyethoxy)silane, γ-(meth)acryloxypropyltrimethoxysilane, γ-(meth)acryloxypropyltriethoxysilane, γ-(meth)acryloxypropylmethyldimethoxysilane, γ-(meth)acryloxypropylmethyldiethoxysilane, γ-(meth)acryloxypropyltriisopropoxysilane, N-β-(N-vinylbenzylaminoethyl)-γ-aminopropyltrimethoxysilane, and hydrochlorides thereof; polymerizable monomers having an aziridinyl group, such as 2-aziridinylethyl (meth)acrylate; polymerizable monomers having an oxazoline group, such as 2-isopropenyl-2-oxazoline and 2-vinyl-2-oxazoline; polymerizable monomers having a cyclopentenyl group, such as dicyclopentenyl (meth)acrylate; and polymerizable monomers having a carboxyl group, such as acrolein and diacetone (meth)acrylamide.

In producing the vinyl resin (x2), in addition to the above (meth)acryl monomers etc., for example, vinyl acetate, vinyl propionate, vinyl butyrate, vinyl versatate, methyl vinyl ether, ethyl vinyl ether, propyl vinyl ether, butyl vinyl ether, amyl vinyl ether, hexyl vinyl ether, (meth)acrylonitrile, styrene, α-methylstyrene, vinyl toluene, vinylanisole, α-halostyrene, vinyl naphthalene, divinylstyrene, isoprene, chloroprene, butadiene, ethylene, tetrafluoroethylene, vinylidene fluoride, N-vinylpyrrolidone, polyethylene glycol mono(meth)acrylate, glycerol mono(meth)acrylate, vinyl sulfonic acid, styrene sulfonic acid, allyl sulfonic acid, 2-methylallyl sulfonic acid, 2-sulfoethyl (meth)acrylate, 2-sulfopropyl (meth)acrylate, and "ADEKA REASOAP PP-70 and PPE-710" (manufactured by ADEKA Corporation), a salt thereof, or the like may be used in combination.

The vinyl resin (x2) such as the acrylic resin can be produced by polymerizing a mixture of the above-described monomers having polymerizable unsaturated double bonds by a known method. An emulsion polymerization method is preferably employed from the viewpoint of producing a conductive pattern having excellent adhesion and excellent electrical conductivity.

Examples of the emulsion polymerization method that can be used include a method in which water, a mixture of monomers having polymerizable unsaturated double bonds, a polymerization initiator, and, as required, a chain transfer agent, an emulsifier, a dispersion stabilizer, etc. are supplied in a reaction vessel at one time, mixed, and polymerized; a monomer-dropping method in which a mixture of monomers having polymerizable unsaturated double bonds is added dropwise into a reaction vessel and polymerized; and a pre-emulsion method in which a mixture prepared by mixing a mixture of monomers having polymerizable unsaturated double bonds, an emulsifier or the like, and water in advance is added dropwise into a reaction vessel and polymerized.

The reaction temperature in the emulsion polymerization method is preferably, for example, about 30°C to 90°C, though it depends on the types of monomers having polymerizable unsaturated double bonds, such as (meth)acrylic monomers and polymerization initiator used. The polymerization time is preferably, for example, about 1 to 10 hours.

Examples of the polymerization initiator that can be used include persulfates such as potassium persulfate, sodium persulfate, and ammonium persulfate; peroxides such as benzoyl peroxide, cumene hydroperoxide, and t-butyl hydroperoxide; and hydrogen peroxide. The polymerization may be conducted by radical polymerization using any of these peroxides alone. Alternatively, the above peroxide may be used in combination with a reducing agent such as ascorbic acid, erythorbic acid, sodium erythorbate, a metal salt of formaldehyde sulfoxylate or the like, sodium thiosulfate, sodium bisulfite, or ferric chloride. An azo initiator such as 4,4'-azobis(4-cyanovaleric acid) and 2,2'-azobis(2-amidinopropane) dihydrochloride may be used as the polymerization initiator.

Examples of the emulsifier that can be used for producing the vinyl resin (x2) such as the acrylic resin include anionic surfactants, nonionic surfactants, cationic surfactants, and amphoteric surfactants.

Examples of the anionic surfactants that can be used include sulfuric acid esters of higher alcohols and salts thereof, alkylbenzenesulfonic acid salts, polyoxyethylene alkyl phenyl sulfonic acid salts, polyoxyethylene alkyl diphenyl ether sulfonic acid salts, sulfuric acid half ester salts of polyoxyethylene alkyl ethers, alkyl diphenyl ether disulfonic acid salts, and succinic acid dialkyl ester sulfonic acid salts. Specifically, "LATEMUL E-118B" (sodium polyoxyethylene alkyl ether sulfate, manufactured by Kao Corporation) can be used. Examples of the nonionic surfactants that can be used include polyoxyethylene alkyl ethers, polyoxyethylene alkyl phenyl ethers, polyoxyethylene diphenyl ether, polyoxyethylene-polyoxypropylene block copolymers, and acetylenediol-based surfactants.

Examples of the cationic surfactants that can be used include an alkyl ammonium salts. Examples of the amphoteric surfactants that can be used include alkyl (amide) betaines and alkyldimethylamine oxides.

Examples of the emulsifier that can be used include, in addition to the above surfactants, fluorine-based surfactants, silicone-based surfactants, and emulsifiers that are generally referred to as "reactive emulsifiers", each of which has a polymerizable unsaturated group in its molecule.

Examples of the reactive emulsifier that can be used include "LATEMUL S-180" (manufactured by Kao Corporation, reactive surfactant having a sulfonic acid group and a salt thereof), "ELEMINOL JS-2 and RS-30" (manufactured by Sanyo Chemical Industries, Ltd.); "Aquaron HS-10, HS-20, and KH-1025" (manufactured by Dai-ichi Kogyo Seiyaku Co., Ltd., reactive surfactant having a sulfate group or a salt thereof), "ADEKA REASOAP SE-10 and SE-20" (manufactured by ADEKA Corporation); "New Frontier A-229E" (manufactured by Dai-ichi Kogyo Seiyaku Co., Ltd., reactive surfactant having a phosphate group); and "Aquaron RN-10, RN-20, RN-30, and RN-50" (manufactured by Dai-ichi Kogyo Seiyaku Co., Ltd., reactive surfactant having a nonionic hydrophilic group).

An example of the chain transfer agent that can be used in the production of the vinyl resin (x2) such as the acrylic resin is lauryl mercaptan. The chain transfer agent is preferably used in an amount in the range of 0% to 1% by mass and more preferably in the range of 0% to 0.5% by mass relative to the total amount of the mixture of monomers having polymerizable unsaturated double bonds, the mixture containing a (meth)acrylic monomer.

As the urethane-vinyl composite resin (x3) that can be used as the compound (b1) contained in the composition (b1-1), it is possible to use composite resin particles that are formed by a urethane resin (x3-1) and a vinyl resin (x3-2) and that can be, for example, dispersed in an aqueous medium.

Specifically, each of the composite resin particles may be a particle in which some or all of the vinyl resin (x3-2) is present in a resin particle formed by the urethane resin (x3-1). The composite resin particles are each preferably a core-shell composite resin particle including the vinyl polymer (x3-2) serving as a core layer and the urethane resin having the hydrophilic group and serving as a shell layer. In particular, in the case where a conductive pattern is formed, the core-shell composite resin particles are preferably used because a surfactant, which may decrease electrical properties, need not be used.

In the case where the vinyl resin (x3-2) is more hydrophilic than the urethane resin (x3-1), each of the composite resin particles may be a composite resin particle in which some or all of the urethane resin (x3-1) is present in a resin particle formed by the vinyl resin (x3-2).

The urethane resin (x3-1) and the vinyl resin (x3-2) may form a covalent bond. However, preferably, the urethane resin (x3-1) and the vinyl resin (x3-2) do not form a bond.

A urethane-acrylic composite resin containing an acrylic resin as the vinyl resin (x3-2) is preferably used as the urethane-vinyl composite resin (x3).

From the viewpoint of maintaining good water dispersion stability, the composite resin particles preferably have an average particle diameter in the range of 5 to 100 nm. Herein, the term "average particle diameter" refers to an average particle diameter on a volume basis measured by a dynamic light scattering method, as described in Examples below.

The urethane-vinyl composite resin (x3) preferably contains the urethane resin (x3-1) and the vinyl resin (x3-2) in the range of [urethane resin (x3-1)/vinyl resin (x3-2)] = 90/10 to 10/90 and more preferably in the range of 70/30 to 10/90.

From the viewpoint of further improving adhesion and electrical conductivity, realizing a thin-line-shaped conductive pattern, and preventing cracks from generating, in the urethane-vinyl composite resin (x3), a urethane resin having an alicyclic structure is preferably used as the urethane resin (x3-1). In addition, a urethane resin having an alicyclic structure is preferably used as the urethane resin (x3-1) from the viewpoint of providing excellent durability at such a level that, in the case where a plating process described below is performed, it is possible to prevent the separation of the primer layer (B) and the conductive layer (A) from the substrate, the separation being caused by the effect of a chemical agent for plating, which is a strong alkali or a strongly acidic substance and used in a step of the plating process.

Examples of the alicyclic structure include a cyclobutyl group, a cyclopentyl group, a cyclohexyl group, a cycloheptyl group, a cyclooctyl group, a propylcyclohexyl group, a tricyclo[5.2.1.0.2.6]decyl group, a bicyclo[4.3.0]-nonyl group, a tricyclo[5.3.1.1]dodecyl group, a propyltricyclo[5.3.1.1]dodecyl group, a norbornene group, an isobornyl group, a dicyclopentanyl group, and an adamantyl group. Among these, a cyclohexyl group, a norbornene group, an isobornyl group, or an adamantyl group is preferable from the viewpoint of obtaining a conductive pattern having excellent durability.

Regarding the urethane resin (x3-1) contained in the urethane-vinyl composite resin (x3), the materials, etc. that are the same as those used for the urethane resin (x1) can be used. Specifically, polyols, polyisocyanates, and chain extenders the same as those described as examples in the production of the urethane resin (x1) can be used as the polyols, the polyisocyanates, and the chain extenders for producing the urethane resin (x3-1). Similarly, in the case where the functional group [X] is introduced into the urethane resin (x3-1), methods the same as those for introducing the functional group [X] into the urethane resin (x1) can be employed.

In the case where a urethane resin having an alicyclic structure is used as the urethane resin (x3-1), a polyol having an alicyclic structure is preferably used as the polyol, and a polyisocyanate having an alicyclic structure is preferably used as the polyisocyanate. By using such a polyol and a polyisocyanate, an alicyclic structure can be introduced into the urethane resin.

Examples of the polyol having an alicyclic structure include polyols each having an alicyclic structure and having a relatively low molecular weight, such as 1,4-cyclohexanedimethanol, cyclobutanediol, cyclopentanediol, 1,4-cyclohexanediol, cycloheptanediol, cyclooctanediol, cyclohexanedimethanol, tricyclo[5.2.1.0.2.6]decanedimethanol, bicyclo[4.3.0]-nonanediol, dicyclohexanediol, tricyclo[5.3.1.1]dodecanediol, bicyclo[4.3.0]nonanedimethanol, tricyclo[5.3.1.1]dodecanediethanol, spiro[3.4]octanediol, butylcyclohexanediol, 1,1'-bicyclohexylidenediol, cyclohexanetriol, hydrogenated bisphenol A, and 1,3-adamantanediol.

As the polyol having an alicyclic structure, in addition to the polyols described above, polyols obtained by reacting a polycarboxylic acid having an alicyclic structure with an aliphatic polyol may also be used.

Examples of the polycarboxylic acid having an alicyclic structure and capable of being used include 1,3-cyclopentanedicarboxylic acid, 1,2-cyclohexanedicarboxylic acid, 1,3-cyclohexanedicarboxylic acid, 1,4-cyclohexanedicarboxylic acid, anhydrides thereof, and esterified products thereof. Among these, a polycarboxylic acid having an alicyclic structure such as 1,2-cyclohexanedicarboxylic acid or 1,4-cyclohexanedicarboxylic acid is preferably used.

Examples of the polyol that can be used in the esterification reaction with the polycarboxylic acid having an alicyclic structure include not only 1,6-hexanediol described above but also aliphatic polyols such as ethylene glycol, diethylene glycol, triethylene glycol, 1,2-propylene glycol, 1,3-propylene glycol, dipropylene glycol, 1,4-butanediol, 1,3-butanediol, 1,2-butanediol, 2,3-butanediol, 1,5-pentanediol, 1,5-hexanediol, 2,5-hexanediol, 1,6-hexanediol, 1,7-heptanediol, 1,8-octanediol, 1,9-nonanediol, 1,10-decanediol, neopentyl glycol, 3-methyl-1,5-pentanediol, and 2-methyl-1,3-propanediol. These aliphatic polyols may be used in combination with the polyol having an alicyclic structure and the polycarboxylic acid when an esterification reaction between the polyol having the alicyclic structure and the polycarboxylic acid is conducted.

As the polyol having an alicyclic structure, for example, a polycarbonate polyol having an alicyclic structure can be used. Examples of the polycarbonate polyol having an alicyclic structure and capable of being used include polycarbonate polyols obtained by a reaction between the above-described polyol having an alicyclic structure and having a low molecular weight and dimethyl carbonate, phosgene, or the like.

As the polycarbonate polyol having an alicyclic structure, a polycarbonate polyol having an alicyclic structure and a number-average molecular weight in the range of 800 to 3,000 is preferably used, and a polycarbonate polyol having an alicyclic structure and a number-average molecular weight in the range of 800 to 2,000 is more preferably used.

As the polyol having an alicyclic structure, for example, a polyether polyol having an alicyclic structure can be used. Examples of the polyether polyol having an alicyclic structure and capable of being used include polyether polyols obtained by addition polymerization of an alkylene oxide such as ethylene oxide or propylene oxide using, as an initiator, the polyol having an alicyclic structure and having a low molecular weight.

As the polyisocyanate having an alicyclic structure and capable of being used in the production of the urethane resin (x3-1), polyisocyanates that have alicyclic structures and that are the same as those described as examples in the production of the urethane resin (x1) can be used.

Similarly, in the case where the hydrophilic group is introduced into the urethane resin (x3-1), polyols that have hydrophilic groups and that are the same as those described as examples in the production of the urethane resin (x1) can be used.

Regarding the vinyl resin (x3-2) contained in the urethane-vinyl composite resin (x3), a vinyl resin having a glass transition temperature of 10°C to 70°C is preferably used from the viewpoint of further improving the adhesion with the conductive substance (a2) contained in the fluid (a) and further improving electrical conductivity of the resulting conductive pattern. Note that the glass transition temperature of the vinyl resin (x3-2) is a value determined by a calculation on the basis of the composition of vinyl monomers used in the production of the vinyl resin (x3-2) .

A vinyl resin having a weight-average molecular weight of preferably 800,000 or more and more preferably 1,000,000 or more is used as the vinyl resin (x3-2) from the viewpoint that the coating film (b) which is a precursor of the primer layer (B) can be formed, the adhesion with the conductive substance (a2) contained in the fluid (a) can be improved, electrical conductivity of the resulting conductive pattern is improved, and a thin-line-shaped pattern is realized.

The upper limit of the weight-average molecular weight of the vinyl resin (x3-2) is not particularly limited, but is preferably 10,000,000 or less and more preferably 5,000,000 or less.

The vinyl resin (x3-2) may have a functional group, as required. Examples of the functional group include cross-linkable functional groups such as an amide group, a hydroxyl group, a glycidyl group, an amino group, a silyl group, an aziridinyl group, an isocyanate group, an oxazoline group, a cyclopentenyl group, an allyl group, a carboxyl group, and an acetoacetyl group.

Regarding the vinyl resin (x3-2), the materials, etc. that are the same as those used for the vinyl resins (x2) can be used. Specifically, vinyl monomers, preferably, (meth)acrylic monomers that are the same as those described as examples in the production of the vinyl resin (x2) can be used as the monometers having polymerizable unsaturated double bonds for producing the vinyl resin (x3-2). Similarly, in the case where the functional group [X] is introduced into the vinyl resin (x3-2), methods the same as those for introducing the functional group [X] into the vinyl resin (x2) can be employed.

The urethane-vinyl composite resin (x3) can be produced by, for example, a step (V) of producing an aqueous dispersion of a urethane resin (x3-1) by reacting the polyisocyanate, the polyol, and, as required, a chain extender with each other and dispersing the resulting resin into water; and a step (W) of producing a vinyl resin (x3-2) by polymerizing a monomer such as the (meth)acrylic monomer in the aqueous dispersion.

Specifically, the polyisocyanate and the polyol are reacted with each other in the absence of a solvent, in the presence of an organic solvent, or in the presence of a reactive diluent such as a (meth)acrylic monomer to prepare a urethane resin (x3-1). Subsequently, as required, some or all of hydrophilic groups of the urethane resin (x3-1) are neutralized by using a basic compound. The resulting product is further reacted with a chain extender, as required, and the resulting urethane resin (x3-1) is dispersed in an aqueous medium. Thus, an aqueous dispersion of the urethane resin (x3-1) is produced.

Subsequently, the monomer such as the (meth)acrylic monomer is supplied in the aqueous dispersion of the urethane resin (x3-1), and the vinyl monomer is subjected to radical polymerization in particles of the urethane resin (x3-1) to produce a vinyl resin (x3-2). Alternatively, in the case where the production of the urethane resin (x3-1) is conducted in the presence of a vinyl monomer, after the production of the urethane resin (x3-1), a polymerization initiator or the like is supplied, thereby causing radical polymerization of the monomer such as the (meth)acrylic monomer. Thus, the vinyl resin (x3-2) is produced.

With this method, it is possible to produce a resin composition that can be used as the compound (b1) contained in the composition (b1-1) and that contains composite resin particles in which part or all of the vinyl resin (x3-2) is present in the particles of the urethane resin (x3-1), the composite resin particles being dispersed in an aqueous medium.

In producing the composite resin particles, in the case where the urethane resin (x3-1) has a high viscosity and thus workability is poor, a common organic solvent such as methyl ethyl ketone, N-methylpyrrolidone, acetone, or dipropylene glycol dimethyl ether, or a reactive diluent may be used. In particular, for example, a monomer, such as a (meth)acrylic monomer, which can be used for producing the vinyl resin (x3-2), is preferably used as the reactive diluent from the viewpoint of improving production efficiency by omitting a step of removing a solvent.

Besides the above-described resins having the functional groups [X], compounds described below may also be used as the compound (b1) having the functional group [X], the compound (b1) being contained in the composition (b1-1). The compounds may be used in combination with the various resins described above. Alternatively, the compounds may be used in combination with resins that do not have the functional groups [X].

In the case where the functional group [X] is an isocyanate group, examples of the compounds other than the resin having the functional group [X] and capable of being used include polyisocyanates such as tolylene diisocyanate, hydrogenated tolylene diisocyanate, triphenylmethane triisocyanate, methylenebis(4-phenylmethane) triisocyanate, isophorone diisocyanate, hexamethylene diisocyanate, and xylylene diisocyanate; nurate-type polyisocyanates obtained by using any of these polyisocyanates; and adducts composed of any of these polyisocyanates and trimethylolpropane or the like. Among these, a nurate of hexamethylene diisocyanate, an adduct of hexamethylene diisocyanate and trimethylolpropane, an adduct of tolylene diisocyanate and trimethylolpropane, or an adduct of xylylene diisocyanate and trimethylolpropane is preferably used.

As the compound having an isocyanate group as the functional group [X], compounds in which some or all of isocyanate groups in the compounds are blocked by a blocking agent may be used.

Examples of the blocking agent that can be used include phenol, cresol, 2-hydroxypyridine, butyl cellosolve, propylene glycol monomethyl ether, benzyl alcohol, methanol, ethanol, n-butanol, isobutanol, dimethyl malonate, diethyl malonate, methyl acetoacetate, ethyl acetoacetate, acetylacetone, butyl mercaptan, dodecyl mercaptan, acetanilide, acetic acid amide, ε-caprolactam, δ-valerolactam, γ-butyrolactam, succinimide, maleimide, imidazole, 2-methylimidazole, urea, thiourea, ethylene urea, formamide oxime, acetaldoxime, acetone oxime, methyl ethyl ketone oxime, methyl isobutyl ketone oxime, cyclohexanone oxime, diphenylaniline, aniline, carbazole, ethyleneimine, and polyethyleneimine.

As the blocked isocyanate compound, for example, Elastron BN-69 (manufactured by Dai-ichi Kogyo Seiyaku Co., Ltd.) can be used as a water-dispersion-type commercially available product.

Examples of the compound having an epoxy group as the functional group [X] and capable of being used include polyglycidyl ethers of aliphatic polyhydric alcohols, such as ethylene glycol diglycidyl ether, propylene glycol diglycidyl ether, hexamethylene glycol diglycidyl ether, cyclohexanediol diglycidyl ether, glycerin diglycidyl ether, glycerin triglycidyl ether, trimethylolpropane triglycidyl ether, and pentaerythritol tetraglycidyl ether; polyglycidyl ethers of polyalkylene glycols, such as polyethylene glycol diglycidyl ether, polypropylene glycol diglycidyl ether, and polytetramethylene glycol diglycidyl ether; polyglycidylamines such as 1,3-bis(N,N'-diglycidylaminoethyl)cyclohexane; polyglycidyl esters of polyvalent carboxylic acids [such as oxalic acid, adipic acid, butanetricarboxylic acid, maleic acid, phthalic acid, terephthalic acid, isophthalic acid, or benzene tricarboxylic acid]; bisphenol A epoxy resins such as a condensate of bisphenol A and epichlorohydrin and an ethylene oxide adduct of a condensate of bisphenol A and epichlorohydrin; phenol novolak resins; and vinyl polymers having an epoxy group in a side chain thereof. Among these, a polyglycidylamine, such as 1,3-bis(N,N'-diglycidylaminoethyl)cyclohexane, and a polyglycidyl ether of an aliphatic polyhydric alcohol, such as glycerin diglycidyl ether, are preferably used.

Examples of the compound having an epoxy group as the functional group [X] and capable of being used include, in addition to the compounds described above, glycidyl group-containing silane compounds such as γ-glycidoxypropyltrimethoxysilane, γ-glycidoxypropyltriethoxysilane, γ-glycidoxypropylmethyldimethoxysilane, γ-glycidoxypropylmethyldiethoxysilane, β-(3,4-epoxycyclohexyl)ethyltrimethoxysilane, β-(3,4-epoxycyclohexyl)ethyltriethoxysilane, β-(3,4-epoxycyclohexyl)ethylmethyldiethoxysilane, and γ-glycidoxypropyltriisopropenyloxysilane.

Examples of the compound having a vinyl group as the functional group [X] and capable of being used include polyfunctional vinyl monomers such as (poly)ethylene glycol di(meth)acrylate, (poly)propylene glycol di(meth)acrylate, (poly)butylene glycol di(meth)acrylate, (poly)neopentyl glycol di(meth)acrylate, N,N'-methylenebis(meth)acrylamide, trimethylolpropane triacrylate, pentaerythritol triacrylate, trimethylolpropane EO-added triacrylate, glycerol PO-added triacrylate, tris acryloyloxyethyl phosphate, pentaerythritol tetraacrylate, tricyclodecanedimethanol diacrylate, dipentaerythritol hexaacrylate, ditrimethylolpropane tetraacrylate, and pentaerythritol tetraacrylate. These compounds may be used in the form of an aqueous dispersion by using any surfactant, as required.

Examples of the compound having, as the functional group [X], a carboxyl group or an anhydrous carboxyl group include vinyl monomers having a carboxylic acid group, such as dibasic acids, i.e., oxalic acid, tartaric acid, succinic acid, malic acid, maleic acid, fumaric acid, phthalic acid, sebacic acid, dodecanedioic acid, eicosanedioic acid, isodocosadiene dioic acid, isodocosane dioic acid, isoeicosane diene dioic acid, butyloctanedioic acid, and dialkoxycarbonyl isodocosadiene dioic acid, and partially neutralized salts thereof, tribasic acids such as citric acid and aconitic acid, and partially neutralized salts thereof, and acrylic acid, methacrylic acid, β-carboxyethyl (meth)acrylate, 2-(meth)acryloyl propionic acid, crotonic acid, itaconic acid, maleic acid, fumaric acid, itaconic acid-half ester, and maleic acid-half ester; and vinyl monomers having a carboxylic anhydride group, such as carboxyl group-containing vinyl monomers, i.e., maleic anhydride, itaconic anhydride, citraconic anhydride, β-(meth)acryloyl oxyethyl hydrogen succinate, citraconic acid, citraconic acid-half ester, and citraconic anhydride. At least one monomer selected from the above monomers can be used.

Examples of the compounds having an N-alkylol group as the functional group [X] and capable of being used include mono- or polymethylol melamines in which 1 to 6 moles of formaldehyde is added relative to 1 mole of melamine, etherified products of (poly)methylol melamine (having any degree of etherification) such as trimethoxymethylol melamine, tributoxymethylol melamine, and hexamethoxymethylol melamine, urea-formaldehyde-methanol condensate, urea-melamine-formaldehyde-methanol condensate, poly N-(alkoxy)methylol (meth)acrylamide, and formaldehyde adducts of poly(meth)acrylamide.

The composition (b1-1) may optionally contain, in addition to the cross-linking agent, for example, a pH adjusting agent, a coating film-forming auxiliary agent, a leveling agent, a thickener, a water-repellent agent, an antifoaming agent, a pigment, an organic filler, and an inorganic filler within a range that does not impair the effects of the present invention.

The cross-linking agent can react with a cross-linkable functional group in the resin. Examples of the cross-linking agent that can be used include a thermal cross-linking agent (d1-1) that reacts at a relatively low temperature of about 25°C to 100°C and that can form a cross-linked structure, such as metal chelate compounds, polyamine compounds, aziridine compounds, metal base compounds, and the above-described isocyanate compounds; and a thermal cross-linking agent (d1-2) that reacts at a relatively high temperature of about 100°C or higher and that can form a cross-linked structure, such as at least one selected from the group consisting of melamine compounds, the above epoxy compounds, oxazoline compounds, carbodiimide compounds, and the above blocked isocyanate compounds. In the case where the cross-linking agent is one that can react with a basic nitrogen atom-containing group of the compound (a1) having the basic nitrogen atom-containing group, the compound (a1) being contained in the conductive layer (A), or a functional group [X] of the compound (b1) contained in the coating film (b), the cross-linking agent may react with some of the groups.

In the case where a composition containing the thermal cross-linking agent (d1-1) is used as the composition (b1-1), for example, the composition is applied onto a surface of a substrate and dried at a relatively low temperature, the fluid (A1) is then applied (printed) and the resulting substrate is then heated to a temperature of lower than 100°C to form a cross-linked structure. Thus, it is possible to form a conductive pattern having excellent durability of such a level that detachment of a conductive substance can be prevented for a long time regardless of the effect of heat or an external force.

On the other hand, in the case where a composition containing the thermal cross-linking agent (d1-2) is used as the composition (b1-1), for example, the composition is applied onto a surface of a substrate and dried at a low temperature in the range of room temperature (25°C) to lower than about 100°C to produce, as the coating film (b), a coating film in which a cross-linked structure is not formed, the fluid (A1) is then applied onto the surface of the coating film, and the resulting substrate is then heated to a temperature of, for example, 150°C or higher and preferably 200°C or higher to form a cross-linked structure. Thus, it is possible to obtain a conductive pattern having excellent durability of such a level that separation or the like of a conductive substance does not occur for a long time regardless of the effect of heat, an external force, or the like. However, in the case where a substrate composed of polyethylene terephthalate or the like, which is relatively sensitive to heat, is used as the substrate, the substrate is preferably heated at a temperature of approximately 150°C or lower and preferably 120°C or lower from the viewpoint of preventing, for example, deformation of the substrate. In such a case, the thermal cross-linking agent (d1-1) rather than the thermal cross-linking agent (d1-2) is preferably used as the cross-linking agent.

Examples of the metal chelate compounds that can be used as the thermal cross-linking agent (d1-1) include acetylacetone coordination compounds and acetoacetic ester coordination compounds of a polyvalent metal such as aluminum, iron, copper, zinc, tin, titanium, nickel, antimony, magnesium, vanadium, chromium, or zirconium. Acetylacetone aluminum, which is an acetylacetone coordination compound of aluminum, is preferably used.

Examples of the polyamine compounds that can be used as the thermal cross-linking agent (d1-1) include tertiary amines such as triethylenediamine, and POLYMENT NK-100PM and NK-200PM (aminoethylated acrylic polymer, manufactured by Nippon Shokubai Co., Ltd.)

Examples of the aziridine compounds that can be used as the thermal cross-linking agent (d1-1) include 2,2-bishydroxymethylbutanol-tris[3-(1-aziridinyl)propionate], 1,6-hexamethylenediethyleneurea, and diphenylmethane-bis-4,4'-N,N'-diethyleneurea.

Examples of the metal base compounds that can be used as the thermal cross-linking agent (d1-1) include aluminum-containing compounds such as aluminum sulfate, aluminum alum, aluminum sulfite, aluminum thiosulfate, polyaluminum chloride, aluminum nitrate nonahydrate, and aluminum chloride hexahydrate; and water-soluble metal salts such as titanium tetrachloride, tetraisopropyl titanate, titanium acetylacetonate, and lactic acid titanium.

Examples of the melamine compounds that can be used as the thermal cross-linking agent (d1-2) include hexamethoxymethylmelamine, hexaethoxymethylmelamine, hexapropoxymethylmelamine, hexabutoxymethylmelamine, hexapentyloxymethylmelamine, hexahexyloxymethylmelamine, and mixed etherified melamines obtained by using two of these melamine compounds in combination. In particular, trimethoxymethylmelamine or hexamethoxymethylmelamine is preferably used. Examples of commercially available products that can be used include Beckamine M-3, APM, and J-101 (manufactured by DIC Corporation). The melamine compounds can form a cross-linked structure by a self-cross-linking reaction.

In the case where the melamine compounds are used, a catalyst such as an organic amine salt may be used in order to accelerate the self-cross-linking reaction. Examples of commercially available products that can be used include Catalyst ACX and 376. The amount of the catalyst is preferably about 0.01% to 10% by mass relative to the total amount of the melamine compound.

Examples of the oxazoline compounds that can be used as the thermal cross-linking agent (d1-2) include 2,2'-bis-(2-oxazoline), 2,2'-methylene-bis-(2-oxazoline), 2,2'-ethylene-bis-(2-oxazoline), 2,2'-trimethylene-bis-(2-oxazoline), 2,2'-tetramethylene-bis-(2-oxazoline), 2,2'-hexamethylene-bis-(2-oxazoline), 2,2'-octamethylene-bis-(2-oxazoline), 2,2'-ethylene-bis-(4,4'-dimethyl-2-oxazoline), 2,2'-p-phenylene-bis-(2-oxazoline), 2,2'-m-phenylene-bis-(2-oxazoline), 2,2'-m-phenylene-bis-(4,4'-dimethyl-2-oxazoline), bis-(2-oxazolinylcyclohexane)sulfide, and bis-(2-oxazolinylnorbornane)sulfide.

Examples of the oxazoline compounds that can be used further include oxazoline group-containing polymers obtained by polymerizing an addition-polymerizable oxazoline described below, as required, in combination with another monomer.

Examples of the addition-polymerizable oxazoline include 2-vinyl-2-oxazoline, 2-vinyl-4-methyl-2-oxazoline, 2-vinyl-5-methyl-2-oxazoline, 2-isopropenyl-2-oxazoline, 2-isopropenyl-4-methyl-2-oxazoline, 2-isopropenyl-5-methyl-2-oxazoline, and 2-isopropenyl-5-ethyl-2-oxazoline. These may be used alone or in combination of two or more compounds. Among these, 2-isopropenyl-2-oxazoline is preferably used because it is industrially easily available.

Examples of the carbodiimide compounds that can be used as the thermal cross-linking agent (d1-2) include poly[phenylenebis(dimethylmethylene)carbodiimide] and poly(methyl-1,3-phenylenecarbodiimide). As commercially available products, for example, Carbodilite V-01, V-02, V-03, V-04, V-05, and V-06 (manufactured by Nisshinbo Holdings Inc.) and UCARLINK XL-29SE and XL-29MP (manufactured by Union Carbide Corporation) can be used.

In general, the cross-linking agent is preferably used in the range of 0.01% to 60% by mass, more preferably 0.1% to 10% by mass, and still more preferably 0.1% to 5% by mass relative to 100 parts by mass of the total mass of the resin contained in the composition (b1-1) because a conductive pattern having excellent adhesion and electrical conductivity, and having excellent durability can be formed, though the amount of cross-linking agent varies depending on, for example, the type of cross-linking agent.

A description will be made of a method for producing a conductive pattern, the method including applying the fluid (A1) onto a part of a surface or an entire surface of the coating film (b) obtained as described above, and then firing the fluid (A1).

Examples of a method for applying the fluid (A1) onto a part of a surface or an entire surface of the coating film (b) include not only reverse printing methods such as a letterpress reverse printing method but also an ink-jet printing method, a screen printing method, an off-set printing method, a spin coating method, a spray coating method, a bar coating method, a die coating method, a slit coating method, a roll coating method, and a dip coating method.

In particular, in the case where the fluid (A1) is applied (printed) so as to form a thin line having a width of about 0.01 to 100 µm, which is required for realizing a high-density electronic circuit or the like, an ink-jet printing method is preferably employed.

In the ink-jet printing method, a device that is generally called an ink-jet printer can be used. Specific examples thereof include Konica Minolta EB100, XY100 (manufactured by Konica Minolta IJ Technologies, Inc.) and Dimatix materials printer DMP-3000 and Dimatix materials printer DMP-2831 (manufactured by FUJI FILM Corporation).

The fluid (A1) contains the compound (a1) having a basic nitrogen atom-containing group, the conductive substance (a2), and, as required, a solvent such as an aqueous medium or an organic solvent. Specifically, the fluid (A1) is a liquid or a viscous liquid having a viscosity of 0.1 to 500,000 mPa·s and preferably 0.5 to 10,000 mPa·s measured at about 25°C with a B-type viscometer. In the fluid (A1), preferably, the conductive substance (a2) is, for example, dispersed in the solvent by a dispersing agent such as the compound (a1) having the basic nitrogen atom-containing group.

In the case where the fluid (A1) is applied (printed) by a method such as an ink-jet printing method, microcontact printing, gravure printing, an off-set printing method, a screen printing method, an off-set printing method, a spin coating method, a spray coating method, a bar coating method, a die coating method, a slit coating method, a roll coating method, or a dip coating method, a fluid whose viscosity is adjusted to the range of about 5 to 20 mPa·s is preferably used.

Specific examples of the fluid (A1) include a conductive ink and a plating nucleus agent that may be used in performing a plating process. The compound (a1) having a basic nitrogen atom-containing group is preferably contained in an amount in the range of 0.01% to 10% by mass relative to the fluid (A1). The conductive substance (a2) is used in an amount in the range of preferably 5% to 90% by mass, more preferably 10% to 60% by mass, and still more preferably 10% to 40% by mass relative to the total amount of the fluid (A1) used in the present invention.

Examples of the compound (a1) that can be used, the compound (a1) having a basic nitrogen atom-containing group and contained in the fluid (A1), include polyalkyleneimines such as polyethyleneimine and polypropyleneimine, and compounds in which a polyoxyalkylene is added to any of the polyalkyleneimines.

From the viewpoint of maintaining good water dispersion stability of the fluid (A1), a compound in which a polyoxyalkylene is added to any of the polyalkyleneimines is preferably used as the compound (a1).

Examples of the polyoxyalkylene that can be used include polyoxyethylene and a random structure or a block structure of poly(oxyethylene-oxypropylene) or the like.

Polyoxyalkylenes having oxyethylene units are preferably used as the polyoxyalkylene from the viewpoint of maintaining good water dispersion stability of the fluid (A1). A polyoxyalkylene having oxyethylene units in the range of 10% to 90% by mass relative to the total of the polyoxyalkylene is preferably used.

Examples of the compound in which a polyoxyalkylene is added to a polyalkyleneimine and which can be used include compounds having a structure composed of polyethyleneimine and the polyoxyalkylene structure such as a polyethylene oxide structure.

The polyethyleneimine and the polyoxyalkylene may be linearly bonded to each other. Alternatively, the polyoxyalkylene may be grafted as a side chain to a main chain formed of the polyethyleneimine.

Specific examples of the compound in which a polyoxyalkylene is added to a polyalkyleneimine and which can be used include copolymers of polyethyleneimine and polyoxyethylene and compounds produced by addition reaction between some of imino groups present in the main chain of such a copolymer and ethylene oxide. These compounds are preferably block copolymers.

Examples of the compound in which a polyoxyalkylene is added to a polyalkyleneimine and which can be used further include compounds produced by reacting an amino group of a polyalkyleneimine, a hydroxyl group of polyoxyethylene glycol, and an epoxy group of an epoxy resin to each other.

Specific examples of the polyalkyleneimine that can be used include PAO2006W, PAO306, PAO318, and PAO718 in PAO series of EPOMIN (registered trademark) manufactured by Nippon Shokubai Co., Ltd.

A polyalkyleneimine having a number-average molecular weight of about 3,000 to 30,000 is preferably used as the polyalkyleneimine.

Examples of the conductive substance (a2) that can be used include transition metals and compounds thereof. Among these, ionic transition metals are preferably used. For example, transition metals such as copper, silver, gold, nickel, palladium, platinum, and cobalt are preferably used. Copper, silver, gold, and the like are more preferably used because a conductive pattern that has a low electrical resistance and that is highly resistant to corrosion can be formed. Silver is still more preferably used.

In the case where the fluid (A1) is used as a plating nucleus agent, it is possible to use, as the conductive substance (a2), for example, at least one selected from metal particles composed of any one of the transition metals described above, metal particles, the surfaces of which are coated with an oxide of any of the transition metals described above, and metal particles, the surfaces of which are coated with an organic substance.

Each of the oxides of the transition metals is usually in an inactive (insulating) state. However, activity (electrical conductivity) can be provided by, for example, treating the oxide with a reducing agent such as dimethylaminoborane to expose a metal.

Examples of the metals, the surfaces of which are coated with an organic substance, include metals included in resin particles (organic substance) formed by an emulsion polymerization method or the like. Each of these surface-coated metals is usually in an inactive (insulating) state. However, activity (electrical conductivity) can be provided by, for example, removing the organic substance by using a laser or the like to expose a metal.

As the conductive substance (a2), particles having an average particle diameter of about 1 to 100 nm are preferably used. Particles having an average particle diameter of 1 to 50 nm are more preferably used because a fine conductive pattern can be formed and the resistance after firing can be further reduced as compared with the case where a conductive substance having an average particle diameter on the order of micrometers is used. Note that the term "average particle diameter" refers to a volume average value measured by a dynamic light scattering method using a sample prepared by diluting the conductive substance (a2) with a good dispersion solvent. A Nanotrac UPA-150 manufactured by Microtrac, Inc. can be used for this measurement.

Examples of the solvent that can be used in the fluid (A1) include aqueous media such as distilled water, ionexchange water, pure water, and ultrapure water; and organic solvents such as alcohols, ethers, esters, and ketones.

Examples of the alcohols that can be used include methanol, ethanol, n-propyl alcohol, isopropyl alcohol, n-butanol, isobutyl alcohol, sec-butanol, tert-butanol, heptanol, hexanol, octanol, nonanol, decanol, undecanol, dodecanol, tridecanol, tetradecanol, pentadecanol, stearyl alcohol, allyl alcohol, cyclohexanol, terpineol, terpineol, dihydroterpineol, ethylene glycol monomethyl ether, ethylene glycol monoethyl ether, ethylene glycol monobutyl ether, diethylene glycol monoethyl ether, diethylene glycol monomethyl ether, diethylene glycol monobutyl ether, tetraethylene glycol monobutyl ether, propylene glycol monomethyl ether, dipropylene glycol monomethyl ether, tripropylene glycol monomethyl ether, propylene glycol monopropyl ether, dipropylene glycol monopropyl ether, propylene glycol monobutyl ether, dipropylene glycol monobutyl ether, and tripropylene glycol monobutyl ether.

In the fluid (a), ketone solvents such as acetone, cyclohexanone, and methyl ethyl ketone may be used in combination in order to adjust physical properties. Furthermore, ester solvents such as ethyl acetate, butyl acetate, 3-methoxybutyl acetate, and 3-methoxy-3-methylbutyl acetate; and hydrocarbon solvents such as toluene, in particular, hydrocarbon solvents having 8 or more carbon atoms may also be used.

Examples of the hydrocarbon solvents having 8 or more carbon atoms include non-polar solvents such as octane, nonane, decane, dodecane, tridecane, tetradecane, cyclooctane, xylene, mesitylene, ethylbenzene, dodecylbenzene, tetralin, trimethylbenzene, and cyclohexane. These hydrocarbon solvents may be used in combination, as required. Furthermore, solvents such as mineral spirits and solvent naphtha, which are mixed solvents, may also be used in combination.

Examples of the solvent that can be used include 2-ethyl-1,3-hexanediol, ethylene glycol, diethylene glycol, triethylene glycol, polyethylene glycol, propylene glycol, dipropylene glycol, 1,2-butanediol, 1,4-butanediol, 2,3-butanediol, glycerol, ethylene glycol monomethyl ether, ethylene glycol monoethyl ether, ethylene glycol monobutyl ether, diethylene glycol monoethyl ether, diethylene glycol monobutyl ether, ethylene glycol monoethyl ether acetate, ethylene glycol monobutyl ether acetate, diethylene glycol monoethyl ether acetate, diethylene glycol monobutyl ether acetate, and glycerol.

The fluid (A1) can be produced by, for example, mixing the compound (a1) having a basic nitrogen atom-containing group, the conductive substance (a2), and, as required, the solvent. Specifically, the fluid (A1) can be produced by adding an ion solution of the conductive substance (a2), the ion solution being prepared in advance, to a medium in which a compound having a branched polyalkyleneimine chain, a hydrophilic segment, and a hydrophobic segment is dispersed, and reducing the metal ions.

A dispersion in which the conductive substance (a2) is dispersed in the solvent such as an aqueous medium or an organic solvent can be used as a composition containing the conductive substance (a2) and the solvent.

The dispersion can be produced by mixing the conductive substance (a2) with the solvent, and stirring the resulting mixture. Specific examples of the dispersion that can be used include Q1N-9P4W-NV75 (manufactured by DIC Corporation), SW1000 (manufactured by Bando Chemical Industries, Ltd.), Silk Auto A-1 (manufactured by Mitsubishi Materials Corporation), and MDot-SLP (manufactured by Mitsuboshi Belting, Co., Ltd.).

The dispersion and the compound (a1) having a basic nitrogen atom-containing group can be mixed at, for example, room temperature. In the mixing, a three-one motor or the like may be used, as required.

In the fluid (A1) used in the present invention, a surfactant, an antifoaming agent, a rheology-controlling agent, etc. may be used, as required, from the viewpoint of improving dispersion stability of the conductive substance (a2) in a solvent such as an aqueous medium or an organic solvent, wettability of the fluid (A1) to a surface of the coating film (b) formed by using the composition (b1-1), etc.

After the fluid (A1) is produced by the above method, if necessary, the fluid (A1) may be filtered with a micropore filter or the like or treated with a centrifugal separator or the like from the viewpoint of removing impurities and the like. The fluid (A1) prepared as described above may also be used.

The resulting product obtained by applying (printing) the fluid (A1) is preferably heated, for example, fired from the viewpoint of providing electrical conductivity by bringing the conductive substance (a2), such as a metal, contained in the fluid (A1) into close contact with each other to join the conductive substance (a2).

The heating such as firing is preferably conducted in the range of about 80°C to 300°C for about 2 to 200 minutes. The heating may be conducted in air. Alternatively, from the viewpoint of preventing oxidation of the metal, part or all of the heating step may be conducted in a reducing atmosphere.

The heating step may be conducted by using, for example, an oven, a hot-air drying furnace, an infrared drying furnace, laser irradiation, microwaves, or light irradiation.

On the surface of the conductive pattern obtained through the heating step, a conductive pattern is formed by the conductive substance (a2) such as a metal contained in the fluid (A1). A basic nitrogen atom-containing group of the compound (a1) having the basic nitrogen atom-containing group, the compound (a1) functioning as a dispersing agent of the conductive substance (a2), reacts with a functional group [X] of the compound (b1) contained in the coating film (b) to form a bond. Thus, a conductive pattern having excellent adhesion can be produced. This conductive pattern can be suitably used in a technical field which is generally called a printed electronics field, for example, peripheral wiring and electronic circuits that are included in an organic solar cell, an electronic book terminal, an organic EL device, an organic transistor, a flexible printed circuit board, RFID, or the like.

A pattern plated with a metal such as copper may be used as the conductive pattern in order to form a highly reliable wiring pattern that can maintain good electrical conduction properties without the occurrence of disconnection or the like for a long time. Specifically, the conductive pattern may include, for example, the coating film (b) on a part of a surface or an entire surface of the substrate, the coating film (b) being formed by using the composition (b1-1); and a plating layer (D) on a part of a surface or an entire surface of the coating film (b), the plating layer (D) being formed of a plating film formed by carrying plating nuclei on the surface of the coating film (b) by applying (printing) a plating nucleus agent serving as the fluid (A1), conducting a firing step or the like as required, and then conducting an electrolytic plating process, an electroless plating process, or an electroless plating process and a subsequent electrolytic plating process.

The step of the electroless plating process is a step of forming an electroless plating layer (coating film) formed of a metal coating film by bringing an electroless plating solution into contact with, for example, a surface of a substrate including the primer layer (B) carrying plating nuclei composed of palladium, silver, or the like thereon to deposit a metal such as copper contained in the electroless plating solution.

For example, a solution containing a conductive substance composed of a metal such as copper, nickel, chromium, cobalt, or tin, a reducing agent, and a solvent such as an aqueous medium or an organic solvent can be used as the electroless plating solution.

Examples of the reducing agent that can be used include dimethylaminoborane, hypophosphorous acid, sodium hypophosphite, dimethylamine borane, hydrazine, formaldehyde, sodium borohydride, and phenols.

The electroless plating solution may contain, as required, complexing agents, for example, organic acids such as monocarboxylic acids, e.g., acetic acid and formic acid; dicarboxylic acids, e.g., malonic acid, succinic acid, adipic acid, maleic acid, and fumaric acid; hydroxycarboxylic acids, e.g., malic acid, lactic acid, glycolic acid, gluconic acid, and citric acid; amino acids, e.g., glycine, alanine, arginine, aspartic acid, and glutamic acid; and aminopolycarboxylic acids, e.g., iminodiacetic acid, nitrilotriacetic acid, ethylenediaminediacetic acid, ethylenediaminetetraacetic acid, and diethylenetriaminepentaacetic acid; soluble salts (such as sodium salts, potassium salts, and ammonium salts) of any of these organic acids; and amines, e.g., ethylenediamine, diethylenetriamine, and triethylenetetramine.

When the electroless plating solution is brought into contact with the surface of the primer layer (B) on which the plating nuclei in the plating nucleus agent are carried, the temperature of the electroless plating solution is preferably in the range of about 20°C to 98°C.

The step of the electrolytic plating process is a step of forming an electrolytic plating film (metal coating film) by supplying electricity in a state in which an electrolytic plating solution is brought into contact with, for example, a surface of the primer layer (B) on which the plating nuclei are carried or a surface of an electroless plating layer (coating film) formed by the electroless process to deposit a metal such as copper contained in the electrolytic plating solution on the surface of the primer layer (B) disposed on the negative electrode or the surface of the electroless plating layer (coating film) formed by the electroless process.

A solution containing a conductive substance composed of a metal such as copper, nickel, chromium, cobalt, or tin, sulfuric acid or the like, and an aqueous medium can be used as the electrolytic plating solution.

When the electrolytic plating solution is brought into contact with the surface of the primer layer (B) on which the plating nuclei in the plating nucleus agent are carried, the temperature of the electrolytic plating solution is preferably in the range of about 20°C to 98°C.

In the electroless plating process or the electrolytic plating process, as described above, a strongly acidic or strongly alkaline plating solution is often used. Therefore, when a common primer layer is used as the primer layer (B), the primer layer (B) is corroded and the primer layer (B) is often separated from a substrate.

The conductive pattern described above can be suitably used in the formation of an electronic circuit using a silver ink or the like, the formation of peripheral wiring that is included in an organic solar cell, an electronic book terminal, an organic EL device, an organic transistor, a flexible printed circuit board, RFID, or the like, and the formation of a conducive pattern, more specifically, a circuit board in producing, for example, wiring of an electromagnetic wave shield of a plasma display.

The conductive pattern produced by the method described above can be provided with excellent durability of such a level that good electrical conduction properties can be maintained without causing, for example, separation of the conductive layer (A) from the primer layer (B) even in the case where the conductive pattern is subjected to a step of a plating process. Accordingly, the conductive pattern can be suitably used in applications that particularly require durability among applications such as the formation of a substrate for forming a circuit using a silver ink or the like, the substrate being used in an electronic circuit, an integrated circuit, or the like; the formation of peripheral wiring that is included in an organic solar cell, an electronic book terminal, an organic EL device, an organic transistor, a flexible printed circuit board, RFID, or the like; and the formation of wiring of an electromagnetic wave shield of a plasma display. In particular, a conductive pattern obtained through the above-described plating process can form a highly reliable wiring pattern that can maintain good electrical conduction properties for a long time without the occurrence of disconnection or the like. Accordingly, for example, such a conductive pattern is generally called a copper clad laminate (CCL) and can be used in applications of a flexible printed circuit board (FPC), tape automated bonding (TAB), a chip-on-film (COF) technology, a printed wiring board (PWB), etc.

### EXAMPLES

The present invention will now be described in detail using Examples.

### [SYNTHESIS EXAMPLE 1] Production of urethane resin (B)-1

In a vessel which was equipped with a thermometer, a nitrogen gas-introducing tube, and a stirrer, and whose atmosphere was replaced with nitrogen, 100 parts by mass of a polyester polyol (polyester polyol prepared by reacting 1,4-cyclohexanedimethanol, neopentyl glycol, and adipic acid, hydroxyl equivalent: 1,000 g/eq.), 17.4 parts by mass of 2,2-dimethylolpropionic acid, 21.7 parts by mass of 1,4-cyclohexanedimethanol, and 106.2 parts by mass of dicyclohexylmethane diisocyanate were mixed and reacted in 178 parts by mass of methyl ethyl ketone. Thus, an organic solvent solution of a urethane prepolymer having an isocyanate group at an end thereof was prepared.

Subsequently, 44.7 parts by mass of pentaerythritol triacrylate was mixed with the organic solvent solution of the urethane prepolymer to allow the urethane prepolymer and pentaerythritol triacrylate to react with each other. Thus, an organic solvent solution of a urethane resin having a vinyl group and a carboxyl group was prepared.

Next, 14.8 parts by mass of triethylamine was added to the organic solvent solution of the urethane resin to neutralize some or all of carboxyl groups in the urethane resin. Furthermore, 380 parts by mass of water was added thereto, and the resulting mixture was sufficiently stirred. Thus, an aqueous dispersion of a urethane resin was prepared.

Next, 8.8 parts by mass of a 25 mass% aqueous solution of ethylenediamine was added to the aqueous dispersion, and the resulting aqueous dispersion was stirred, thereby conducting chain extension of the urethane resin. Subsequently, the aqueous dispersion was subjected to aging and removal of the solvent. Thus, an aqueous dispersion of a urethane resin (B)-1 having a solid content of 30% by mass was prepared. The urethane resin (B)-1 prepared in this example had an acid value of 30 and a weight-average molecular weight of 82,000.

### [SYNTHESIS EXAMPLE 2] Production of urethane resin (B)-2

In a vessel which was equipped with a thermometer, a nitrogen gas-introducing tube, and a stirrer, and whose atmosphere was replaced with nitrogen, 100 parts by mass of a polyester polyol (polyester polyol prepared by reacting 1,4-cyclohexanedimethanol, neopentyl glycol, and adipic acid, hydroxyl equivalent: 1,000 g/eq.), 17.4 parts by mass of 2,2-dimethylolpropionic acid, 21.7 parts by mass of 1,4-cyclohexanedimethanol, and 106.2 parts by mass of dicyclohexylmethane diisocyanate were mixed and reacted in 178 parts by mass of methyl ethyl ketone. Thus, an organic solvent solution of a urethane prepolymer having an isocyanate group at a molecular end thereof was prepared.

Next, 13.3 parts by mass of triethylamine was added to the organic solvent solution of the urethane prepolymer to neutralize some or all of carboxyl groups in the urethane resin. Furthermore, 277 parts by mass of water was added thereto, and the resulting mixture was sufficiently stirred. Thus, an aqueous dispersion of a urethane resin having a carboxyl group was prepared.

Next, 8 parts by mass of a 25 mass% aqueous solution of ethylenediamine was added to the aqueous dispersion, and the resulting aqueous dispersion was stirred, thereby conducting chain extension of the urethane resin. Subsequently, the aqueous dispersion was subjected to aging and removal of the solvent. Thus, an aqueous dispersion of a urethane resin (B)-2 having a solid content of 30% by mass was prepared. The urethane resin (B)-2 prepared in this example had an acid value of 30 and a weight-average molecular weight of 55,000.

### [SYNTHESIS EXAMPLE 3] Production of urethane resin (B)-3

In a vessel which was equipped with a thermometer, a nitrogen gas-introducing tube, and a stirrer, and whose atmosphere was replaced with nitrogen, 100 parts by mass of a polyether polyol in which propylene oxide is added to bisphenol A (hydroxyl equivalent: 1,000 g/eq.), 21.6 parts by mass of 1,4-cyclohexanedimethanol, and 66.8 parts by mass of dicyclohexylmethane diisocyanate were mixed and reacted in 178 parts by mass of methyl ethyl ketone. Thus, an organic solvent solution of a urethane prepolymer having an isocyanate group at an end thereof was prepared.

Subsequently, 9.6 parts by mass of methyl ethyl ketone oxime was mixed with the organic solvent solution of the urethane prepolymer to allow the urethane prepolymer and methyl ethyl ketone oxime to react with each other. Thus, an organic solvent solution of a urethane resin (B)-3 having a blocked isocyanate group was prepared.

### [SYNTHESIS EXAMPLE 4] Production of urethane resin (B)'-1

In a vessel which was equipped with a thermometer, a nitrogen gas-introducing tube, and a stirrer, and whose atmosphere was replaced with nitrogen, 100 parts by mass of a polyester polyol (polyester polyol prepared by reacting 1,4-cyclohexanedimethanol, neopentyl glycol, and adipic acid, hydroxyl equivalent: 1,000 g/eq.), 21.6 parts by mass of 1,4-cyclohexanedimethanol, and 59 parts by mass of dicyclohexylmethane diisocyanate were mixed and reacted in 164 parts by mass of methyl ethyl ketone. Thus, an organic solvent solution of a urethane prepolymer having an isocyanate group at an end thereof was prepared.

Subsequently, 2.1 parts by mass of methanol was mixed with the organic solvent solution of the urethane prepolymer to allow the urethane prepolymer and methanol to react with each other. Thus, an organic solvent solution of a urethane resin (B)'-1 that did not have a functional group [X] was prepared.

### [SYNTHESIS EXAMPLE 5] Production of vinyl polymer (B)-4

In a reaction vessel equipped with a stirrer, a reflux condenser, a nitrogen-introducing tube, a thermometer, and dropping funnels, 115 parts by mass of deionized water and 4 parts by mass of LATEMUL E-118B (manufactured by Kao Corporation, active ingredient: 25% by mass) were put, and the temperature was increased to 75°C while blowing nitrogen.

Part (5 parts by mass) of a monomer pre-emulsion prepared by mixing a vinyl monomer mixture containing 48 parts by mass of methyl methacrylate, 45 parts by mass of n-butyl acrylate, 2 parts by mass of methacrylic acid, and 5 parts by mass of 2-hydroxyethyl methacrylate, 4 parts by mass of Aquaron KH-1025 (manufactured by Dai-ichi Kogyo Seiyaku Co., Ltd., active ingredient: 25% by mass), and 15 parts by mass of deionized water was added to the reaction vessel under stirring. Subsequently, 0.1 parts by mass of potassium persulfate was added thereto, and polymerization was conducted for 60 minutes while maintaining the temperature in the reaction vessel at 75°C.

Next, the rest (114 parts by mass) of the monomer pre-emulsion and 30 parts by mass of an aqueous solution (active ingredient: 1.0% by mass) of potassium persulfate were respectively added dropwise over a period of 180 minutes using two dropping funnels while maintaining the temperature in the reaction vessel at 75°C. After the completion of the dropwise addition, the resulting mixture was stirred at the same temperature for 60 minutes.

The temperature in the reaction vessel was decreased to 40°C, and aqueous ammonia (active ingredient: 10% by mass) was used so that the pH of the aqueous dispersion in the reaction vessel became 8.5.

Subsequently, deionized water was used so that the non-volatile content became 20% by mass, and the resulting dispersion was then filtered with a 200-mesh filter cloth. Thus, an aqueous dispersion of a vinyl polymer (B)-4 having a carboxyl group was prepared.

### [SYNTHESIS EXAMPLE 6] Production of vinyl polymer (B)-5

In a reaction vessel equipped with a stirrer, a reflux condenser, a nitrogen-introducing tube, a thermometer, and dropping funnels, 115 parts by mass of deionized water and 4 parts by mass of LATEMUL E-118B (manufactured by Kao Corporation, active ingredient: 25% by mass) were put, and the temperature was increased to 75°C while blowing nitrogen.

Part (5 parts by mass) of a monomer pre-emulsion prepared by mixing a vinyl monomer mixture containing 46 parts by mass of methyl methacrylate, 45 parts by mass of n-butyl acrylate, 2 parts by mass of methacrylic acid, 5 parts by mass of 2-hydroxyethyl methacrylate, and 2 parts by mass of N-methylolacrylamide, 4 parts by mass of Aquaron KH-1025 (manufactured by Dai-ichi Kogyo Seiyaku Co., Ltd., active ingredient: 25% by mass), and 15 parts by mass of deionized water was added to the reaction vessel under stirring. Subsequently, 0.1 parts by mass of potassium persulfate was added thereto, and polymerization was conducted for 60 minutes while maintaining the temperature in the reaction vessel at 75°C.

Next, the rest (114 parts by mass) of the monomer pre-emulsion and 30 parts by mass of an aqueous solution (active ingredient: 1.0% by mass) of potassium persulfate were respectively added dropwise over a period of 180 minutes using two dropping funnels while maintaining the temperature in the reaction vessel at 75°C. After the completion of the dropwise addition, the resulting mixture was stirred at the same temperature for 60 minutes.

The temperature in the reaction vessel was decreased to 40°C, and aqueous ammonia (active ingredient: 10% by mass) was used so that the pH of the aqueous dispersion in the reaction vessel became 8.5.

Subsequently, deionized water was used so that the non-volatile content became 20% by mass, and the resulting dispersion was then filtered with a 200-mesh filter cloth. Thus, an aqueous dispersion of a vinyl polymer (B)-5 having a carboxyl group and an N-methylolacrylamide group was prepared.

### [SYNTHESIS EXAMPLE 7] Production of vinyl polymer (B)-6

In a reaction vessel equipped with a stirrer, a reflux condenser, a nitrogen-introducing tube, a thermometer, and dropping funnels, 115 parts by mass of deionized water and 4 parts by mass of LATEMUL E-118B (manufactured by Kao Corporation, active ingredient: 25% by mass) were put, and the temperature was increased to 75°C while blowing nitrogen.

Part (5 parts by mass) of a monomer pre-emulsion prepared by mixing a vinyl monomer mixture containing 46 parts by mass of methyl methacrylate, 43 parts by mass of n-butyl acrylate, 2 parts by mass of methacrylic acid, 5 parts by mass of 2-hydroxyethyl methacrylate, and 4 parts by mass of diacetone acrylamide, 4 parts by mass of Aquaron KH-1025 (manufactured by Dai-ichi Kogyo Seiyaku Co., Ltd., active ingredient: 25% by mass), and 15 parts by mass of deionized water was added to the reaction vessel under stirring. Subsequently, 0.1 parts by mass of potassium persulfate was added thereto, and polymerization was conducted for 60 minutes while maintaining the temperature in the reaction vessel at 75°C.

Next, the rest (114 parts by mass) of the monomer pre-emulsion and 30 parts by mass of an aqueous solution (active ingredient: 1.0% by mass) of potassium persulfate were respectively added dropwise over a period of 180 minutes using two dropping funnels while maintaining the temperature in the reaction vessel at 75°C. After the completion of the dropwise addition, the resulting mixture was stirred at the same temperature for 60 minutes.

The temperature in the reaction vessel was decreased to 40°C, and aqueous ammonia (active ingredient: 10% by mass) was used so that the pH of the aqueous dispersion in the reaction vessel became 8.5.

Subsequently, deionized water was used so that the non-volatile content became 20% by mass, and the resulting dispersion was then filtered with a 200-mesh filter cloth. Thus, an aqueous dispersion of a vinyl polymer (B)-6 having a carboxyl group and a keto group was prepared.

### [SYNTHESIS EXAMPLE 8] Production of vinyl polymer (B)-7

In a reaction vessel equipped with a stirrer, a reflux condenser, a nitrogen-introducing tube, a thermometer, and dropping funnels, a vinyl monomer mixture containing 48 parts by mass of methyl methacrylate, 43 parts by mass of n-butyl acrylate, 5 parts by mass of 2-hydroxyethyl methacrylate, and 4 parts by mass of "Karenz MOI-BM" (manufactured by Showa Denko K.K., blocked isocyanate group-containing vinyl monomer), and 400 parts by mass of ethyl acetate were mixed, and the temperature was increased to 50°C while stirring was conducted in a nitrogen atmosphere. Subsequently, 2 parts by mass of 2,2'-azobis(2-methyl butyronitrile) was charged, and the resulting mixture was allowed to react for 24 hours. Thus, an ethyl acetate solution of a vinyl polymer (B)-7, namely, 500 parts by mass (non-volatile content: 20% by mass) of a mixture containing a vinyl polymer having a blocked isocyanate group and a weight-average molecular weight of 400,000 and ethyl acetate was prepared.

### [SYNTHESIS EXAMPLE 9] Production of vinyl polymer (B)-8

In a reaction vessel equipped with a stirrer, a reflux condenser, a nitrogen-introducing tube, a thermometer, and dropping funnels, a vinyl monomer mixture containing 48 parts by mass of methyl methacrylate, 43 parts by mass of n-butyl acrylate, 5 parts by mass of 2-hydroxyethyl methacrylate, and 4 parts by mass of glycidyl methacrylate, and 400 parts by mass of ethyl acetate were mixed, and the temperature was increased to 50°C while stirring was conducted in a nitrogen atmosphere. Subsequently, 2 parts by mass of 2,2'-azobis(2-methyl butyronitrile) was charged, and the resulting mixture was allowed to react for 24 hours. Thus, an ethyl acetate solution of a vinyl polymer (B)-8, namely, 500 parts by mass (non-volatile content: 20% by mass) of a mixture containing a vinyl polymer having a glycidyl group and a weight-average molecular weight of 400,000 and ethyl acetate was prepared.

### [SYNTHESIS EXAMPLE 10] Production of vinyl polymer (B)-9

In a reaction vessel equipped with a stirrer, a reflux condenser, a nitrogen-introducing tube, a thermometer, and dropping funnels, a vinyl monomer mixture containing 48 parts by mass of methyl methacrylate, 45 parts by mass of n-butyl acrylate, 5 parts by mass of 2-hydroxyethyl methacrylate, and 2 parts by mass of maleic anhydride, and 400 parts by mass of ethyl acetate were mixed, and the temperature was increased to 50°C while stirring was conducted in a nitrogen atmosphere. Subsequently, 2 parts by mass of 2,2'-azobis(2-methyl butyronitrile) was charged, and the resulting mixture was allowed to react for 24 hours. Thus, an ethyl acetate solution of a vinyl polymer (B)-9, namely, 500 parts by mass (non-volatile content: 20% by mass) of a mixture containing a vinyl polymer having a carboxylic anhydride group and a weight-average molecular weight of 400,000 and ethyl acetate was prepared.

### [SYNTHESIS EXAMPLE 11] Production of vinyl polymer (B)'-2

In a reaction vessel equipped with a stirrer, a reflux condenser, a nitrogen-introducing tube, a thermometer, and dropping funnels, a vinyl monomer mixture containing 49 parts by mass of methyl methacrylate, 46 parts by mass of n-butyl acrylate, and 5 parts by mass of 2-hydroxyethyl methacrylate, and 400 parts by mass of ethyl acetate were put, and the temperature was increased to 50°C while stirring was conducted in a nitrogen atmosphere. Subsequently, 2 parts by mass of 2,2'-azobis(2-methyl butyronitrile) was charged, and the resulting mixture was allowed to react for 24 hours. Thus, an ethyl acetate solution of a vinyl polymer (B)'-2, namely, 500 parts by mass (non-volatile content: 20% by mass) of a mixture containing a vinyl polymer having a weight-average molecular weight of 400,000 and ethyl acetate was prepared.

### [SYNTHESIS EXAMPLE 12] Production of urethane-acrylic composite resin (B)-10

In a reaction vessel equipped with a stirrer, a reflux condenser, a nitrogen-introducing tube, a thermometer, dropping funnel for dropping a monomer mixture, and a dropping funnel for dropping a polymerization catalyst, 280 parts by mass of deionized water and 333 parts by mass of the aqueous dispersion of the urethane resin (B)-2 prepared above were put, and the temperature was increased to 80°C while blowing nitrogen.

In order to prepare a vinyl polymer (B)-4 constituting a core layer, a monomer mixture containing 48 parts by mass of methyl methacrylate, 44 parts by mass of n-butyl acrylate, and 8 parts by mass of 2-hydroxyethyl methacrylate, and 20 parts by mass of an aqueous solution of ammonium persulfate (concentration: 0.5% by mass) were added dropwise to the reaction vessel, the temperature of which was increased to 80°C, from the separate dropping funnels under stirring over a period of 120 minutes while maintaining the temperature in the reaction vessel at 80°C ± 2°C, thus conducting polymerization.

After the completion of the dropwise addition, the resulting reaction mixture was stirred at the same temperature for 60 minutes. The temperature in the reaction vessel was then decreased to 40°C. Subsequently, deionized water was used so that the non-volatile content became 20% by mass. The resulting dispersion was then filtered with a 200-mesh filter cloth. Thus, an aqueous dispersion of composite resin particles (B)-10 each including a shell layer composed of the urethane resin (B)-2 and a core layer composed of the vinyl polymer having a carboxyl group was prepared.

### [SYNTHESIS EXAMPLE 13] Production of urethane-acrylic composite resin (B)-11

In a reaction vessel equipped with a stirrer, a reflux condenser, a nitrogen-introducing tube, a thermometer, a dropping funnel for dropping a monomer mixture, and a dropping funnel for dropping a polymerization catalyst, 280 parts by mass of deionized water and 333 parts by mass of the aqueous dispersion of the urethane resin (B)-2 prepared above were put, and the temperature was increased to 80°C while blowing nitrogen.

In order to prepare a vinyl polymer (B)-5 constituting a core layer, a monomer pre-emulsion prepared by mixing a vinyl monomer mixture containing 46 parts by mass of methyl methacrylate, 45 parts by mass of n-butyl acrylate, 2 parts by mass of methacrylic acid, 4 parts by mass of 2-hydroxyethyl methacrylate, and 4 parts by mass of N-n-butoxymethylacrylamide, 4 parts by mass of Aquaron KH-1025 (manufactured by Dai-ichi Kogyo Seiyaku Co., Ltd., active ingredient: 25% by mass), and 15 parts by mass of deionized water, and 20 parts by mass of an aqueous solution of ammonium persulfate (concentration: 0.5% by mass) were added dropwise to the reaction vessel, the temperature of which was increased to 80°C, from the separate dropping funnels under stirring over a period of 120 minutes while maintaining the temperature in the reaction vessel at 80°C ± 2°C, thus conducting polymerization.

After the completion of the dropwise addition, the resulting reaction mixture was stirred at the same temperature for 60 minutes. The temperature in the reaction vessel was then decreased to 40°C. Subsequently, deionized water was used so that the non-volatile content became 20% by mass. The resulting dispersion was then filtered with a 200-mesh filter cloth. Thus, an aqueous dispersion of composite resin particles (B)-11 each including a shell layer composed of the urethane resin (B)-2 and a core layer composed of the vinyl polymer (B)-5 having a carboxyl group and an N-n-butoxymethylacrylamide group was prepared.

### [SYNTHESIS EXAMPLE 14] Production of urethane-acrylic composite resin (B)-12

In a reaction vessel equipped with a stirrer, a reflux condenser, a nitrogen-introducing tube, a thermometer, a dropping funnel for dropping a monomer mixture, and a dropping funnel for dropping a polymerization catalyst, 280 parts by mass of deionized water and 400 parts by mass of the aqueous dispersion of the urethane resin (B)-2 prepared above were put, and the temperature was increased to 80°C while blowing nitrogen.

In order to prepare a vinyl polymer (B)-6 constituting a core layer, a monomer mixture containing 34 parts by mass of methyl methacrylate, 30 parts by mass of n-butyl acrylate, 6 parts by mass of 2-hydroxyethyl methacrylate, and 10 parts by mass of diacetone acrylamide, and 20 parts by mass of an aqueous solution of ammonium persulfate (concentration: 0.5% by mass) were added dropwise to the reaction vessel, the temperature of which was increased to 80°C, from the separate dropping funnels under stirring over a period of 120 minutes while maintaining the temperature in the reaction vessel at 80°C ± 2°C, thus conducting polymerization.

After the completion of the dropwise addition, the resulting reaction mixture was stirred at the same temperature for 60 minutes. The temperature in the reaction vessel was then decreased to 40°C. Subsequently, deionized water was used so that the non-volatile content became 20% by mass. The resulting dispersion was then filtered with a 200-mesh filter cloth. Thus, an aqueous dispersion of composite resin particles (B)-12 each including a shell layer composed of the urethane resin (B)-2 and a core layer composed of the vinyl polymer (B)-6 having a carboxyl group and a keto group was prepared.

### [SYNTHESIS EXAMPLE 15] Production of urethane-acrylic composite resin (B)-13

In a reaction vessel equipped with a stirrer, a reflux condenser, a nitrogen-introducing tube, a thermometer, a dropping funnel for dropping a monomer mixture, and a dropping funnel for dropping a polymerization catalyst, 280 parts by mass of deionized water and 400 parts by mass of the aqueous dispersion of the urethane resin (B)-2 prepared above were put, and the temperature was increased to 80°C while blowing nitrogen.

In order to prepare a vinyl polymer (B)-8 constituting a core layer, a monomer mixture containing 36 parts by mass of methyl methacrylate, 34 parts by mass of n-butyl acrylate, 6 parts by mass of 2-hydroxyethyl methacrylate, and 4 parts by mass of glycidyl methacrylate, and 20 parts by mass of an aqueous solution of ammonium persulfate (concentration: 0.5% by mass) were added dropwise to the reaction vessel, the temperature of which was increased to 80°C, from the separate dropping funnels under stirring over a period of 120 minutes while maintaining the temperature in the reaction vessel at 80°C ± 2°C, thus conducting polymerization.

After the completion of the dropwise addition, the resulting reaction mixture was stirred at the same temperature for 60 minutes. The temperature in the reaction vessel was then decreased to 40°C. Subsequently, deionized water was used so that the non-volatile content became 20% by mass. The resulting dispersion was then filtered with a 200-mesh filter cloth. Thus, an aqueous dispersion of composite resin particles (B)-15 each including a shell layer composed of the urethane resin (B)-2 and a core layer composed of the vinyl polymer (B)-8 having a glycidyl group was prepared.

### EXAMPLE 1

The aqueous dispersion of the urethane resin (B)-1 prepared as described above was applied onto a surface of a substrate formed of a polyimide film (manufactured by Du Pont-Toray Co., Ltd., Kapton 150ENC, thickness 50 µm) with a spin coater so that the dry film thickness became 1 µm. The resulting substrate was dried at 80°C for three minutes using a hot-air dryer. Thus, a laminate including the substrate and a coating film formed on the substrate, the coating film being a precursor of a primer layer, was prepared.

A straight line having a line width of 100 µm and a film thickness of 0.5 µm was printed on a surface of the coating film included in the laminate so as to have a length of about 1 cm using a fluid 1 described below with an ink-jet printer (manufactured by Konica Minolta IJ Technologies, Inc., ink-jet testing device EB100, printer head for evaluation: KM512L, the amount of ejection: 42 pL). The resulting laminate was then fired at 150°C for 30 minutes to obtain a conductive pattern in which a layer (C) formed of the substrate, a primer layer (B), and a conductivity (A) are stacked and an imino group in the conductive layer (A) and a portion corresponding to a functional group [X] of the primer layer (B) are reacted and bonded with each other.

### [Preparation of fluid 1]

A chloroform (30 mL) solution containing 9.6 g of p-toluenesulfonic acid chloride was added dropwise to a mixture containing 20 g of methoxypolyethylene glycol (number-average molecular weight: 2,000), 8.0 g of pyridine, and 20 mL of chloroform in a nitrogen atmosphere over a period of 30 minutes while stirring under ice cooling. The resulting mixture was then stirred for four hours at a bath temperature of 40°C, and 50 mL of chloroform was mixed therewith.

Subsequently, the resulting product was washed with 100 mL of a 5 mass% aqueous hydrochloric acid solution, then 100 mL of a saturated aqueous sodium hydrogencarbonate solution, and then 100 mL of a saturated saline solution. The resulting product was then dried with anhydrous magnesium sulfate, filtered, and concentrated under reduced pressure. The resulting product was then washed with hexane several times, then filtered, and dried at 80°C under reduced pressure. Thus, methoxypolyethylene glycol having a p-toluenesulfonyloxy group was prepared.

Subsequently, 5.39 g of the methoxypolyethylene glycol having a p-toluenesulfonyloxy group, 20 g of polyethyleneimine (manufactured by Aldrich, molecular weight: 25,000), 0.07 g of potassium carbonate, and 100 mL of N,N-dimethylacetamide were mixed. The resulting mixture was stirred at 100°C for six hours in a nitrogen atmosphere.

Subsequently, 300 mL of a mixed solution of ethyl acetate and hexane (volume ratio of ethyl acetate/hexane = 1/2) was added to the mixture. The mixture was vigorously stirred at room temperature, and solid matter of the resulting product was then filtered. The solid matter was washed with 100 mL of a mixed solution of ethyl acetate and hexane (volume ratio of ethyl acetate/hexane = 1/2), and then dried under reduced pressure. Thus, a compound in which polyethylene glycol was bonded to polyethyleneimine was prepared.

Subsequently, 138.8 g of an aqueous solution containing 0.592 g of the compound in which polyethylene glycol was bonded to polyethyleneimine was mixed with 10 g of silver oxide, and the resulting mixture was stirred at 25°C for 30 minutes.

Subsequently, 46 g of dimethylethanolamine was gradually added to the mixture while stirring, and the mixture was stirred at 25°C for 30 minutes.

Subsequently, 15.2 g of a 10 mass% aqueous solution of ascorbic acid was gradually added to the mixture while stirring, and stirring was continued for 20 hours. Thus, a dispersion of silver was prepared.

A mixed solvent of 200 mL of isopropyl alcohol and 200 mL of hexane was added to the dispersion of silver, and stirring was conducted for two minutes. Centrifugal concentration was then conducted at 3,000 rpm for 5 minutes. After the supernatant was removed, a mixed solvent of 50 mL of isopropyl alcohol and 50 mL of hexane was added to the precipitate and stirring was conducted for two minutes. Centrifugal concentration was then conducted at 3,000 rpm for 5 minutes. After the supernatant was removed, 20 g of water was further added to the precipitate and stirring was conducted for two minutes. The organic solvent was then removed under reduced pressure. Furthermore, 10 g of water was added, and the resulting mixture was stirred and dispersed. The resulting dispersion was then allowed to stand in a freezer at -40°C for one day and night to be frozen. The frozen product was treated in a freeze dryer (manufactured by Tokyo Rikakikai Co., Ltd., FDU-2200) for 24 hours to obtain a grayish green, metallic luster silver-containing powder in the form of a flaky mass.

Subsequently, 25.9 g of the silver-containing powder prepared as described above was mixed with 45 g of ethylene glycol and 55 g of ion-exchange water, and the mixture was stirred for three hours. Thus, a fluid 1 that could be used as a conductive ink for ink-jet printing was prepared (silver content: 20% by mass, mass ratio of polyethyleneimine: 1% by mass, viscosity: 10 mPa·s).

### EXAMPLES 2 and 3 and COMPARATIVE EXAMPLE 1

Conductive patterns of Examples 2 and 3 and Comparative Example 1 were obtained by the same method as that described in Example 1 except that the urethane resins (B)-2, (B)-3, and (B)'-1 described in Table 1 below were respectively used instead of the urethane resin (B)-1.

### EXAMPLES 4 to 9

Conductive patterns of Examples 4 to 9 were obtained by the same method as that described in Example 1 except that the vinyl polymers (B)-4 to (B)-9 described in Table 2 below were respectively used instead of the urethane resin (B)-1.

### COMPARATIVE EXAMPLES 2 and 3

A conductive pattern of Comparative Example 2 was obtained by the same method as that described in Example 4 except that the vinyl resin (B)'-2 described in Table 2 below was used instead of the vinyl resin (B)-4. A conductive pattern of Comparative Example 3 was obtained by the same method as that described in Example 4 except that a fluid 2 was used instead of the fluid 1. A fluid prepared as described below was used as the fluid 2.

Silver particles having an average particle diameter of 30 nm were dispersed in 70 parts by mass of tetradecane using oleic acid, and the viscosity of the resulting dispersion was adjusted to 10 mPa·s. Thus, a fluid 2 that could be used as a conductive ink for ink-jet printing and that did not contain polyethyleneimine was prepared.

### EXAMPLES 10 to 13

Conductive patterns of Examples 10 to 13 were obtained by the same method as that described in Example 1 except that the urethane-acrylic composite resins (B)-10 to (B)-13 described in Table 3 below were respectively used instead of the urethane resin (B)-1.

### [Method for evaluating adhesion between conductive layer and primer layer]

A cellophane adhesive tape (manufactured by Nichiban Co., Ltd., CT405AP-24, 24 mm) was applied onto a surface of the conductive layer included in the conductive pattern by pressing with a finger. The cellophane adhesive tape was then peeled off in a direction at an angle of 90 degrees with respect to the surface of the conductive pattern. The adhesive surface of the peeled cellophane adhesive tape was visually observed. The adhesion was evaluated on the basis of the presence or absence of a substance adhering to the adhesive surface of the tape.

In the case where a conductive layer containing silver did not adhere to the adhesive surface of the peeled cellophane adhesive tape, the sample was evaluated as "A". In the case where less than 3% of the area of the conductive layer relative to the area in which the conductive layer and the adhesive tape are in contact with each other was detached from the primer layer and adhered to the adhesive surface of the adhesive tape, the sample was evaluated as "B". In the case where 3% or more and less than 30% of the area of the conductive layer relative to the area in which the conductive layer and the adhesive tape are in contact with each other was detached from the primer layer and adhered to the adhesive surface of the adhesive tape, the sample was evaluated as "C". In the case where 30% or more of the area of the conductive layer relative to the area in which the conductive layer and the adhesive tape are in contact with each other was detached from the primer layer and adhered to the adhesive tape, the sample was evaluated as "D".

### [Method for evaluating adhesion when conductive pattern was bent (bending adhesion)]

A surface of the conductive layer included in the conductive pattern was set to a cathode, and phosphorus-containing copper was set to an anode. Electroplating was conducted using an electroplating solution containing copper sulfate at a current density of 2 A/dm² for 15 minutes. A copper plating layer having a thickness of 8 µm was stacked on the surface of the conductive layer. The electroplating solution used contained 70 g/L of copper sulfate, 200 g/L of sulfuric acid, 50 mg/L of chlorine ion, and 5 g/L of Top Lucina SF (brightener, manufactured by Okuno Chemical Industries Co., Ltd.).

The resulting sample was bent by 180 degrees such that the plating layer included in the conductive pattern obtained as described above was disposed on the outside and then returned to the original state. In this test, in the case where separation between the conductive layer and the plating layer was not confirmed by visual observation, the sample was evaluated as "A". In the case where a small part of the conductive layer was separated from the primer layer, the sample was evaluated as "B". In the case where a part of the conductive layer was separated from the primer layer, the sample was evaluated as "C". In the case where a part of the conductive layer was separated from the primer layer in the course of the plating step, the sample was evaluated as "D".

**[Table 1]**

| Table 1 | | Example 1 | Example 2 | Example 3 | Comparative Example 1 |
|---|---|---|---|---|---|
| Urethane resin | | (B)-1 | (B)-2 | (B)-3 | (B)'-1 |
| Functional group [X] | | Carboxyl group Vinyl group | Carboxyl group | Isocyanate group | None |
| Content of functional group [X] | Content of carboxyl group (mmol/kg) | 500 | 530 | 0 | 0 |
| | Content of functional group [X] other than carboxyl group (mmol/kg) | 577 | 992 | 1,068 | 0 |
| Fluid | | Fluid 1 | Fluid 1 | Fluid 1 | Fluid 1 |
| Adhesion | | A | B | B | D |
| Bending adhesion | | A | B | B | D |

**[Table 2]**

| Table 2 | | Example 4 | Example 5 | Example 6 | Example 7 |
|---|---|---|---|---|---|
| Vinyl resin | | (B)-4 | (B)-5 | (B)-6 | (B)-7 |
| Functional group [X] | | Carboxyl group | Carboxyl group N-Methylolacrylamide group | Carboxyl group Keto group | Isocyanate group |
| Content of functional group [X] | Content of carboxyl group (mmol/kg) | 233 | 233 | 233 | 0 |
| | Content of functional group [X] other than carboxyl group (mmol/kg) | 0 | 198 | 237 | 167 |
| Fluid | | Fluid 1 | Fluid 1 | Fluid 1 | Fluid 1 |
| Adhesion | | B | A | A | B |
| Bending adhesion | | B | A | A | B |

**[Table 3]**

| Table 3 | | Example 8 | Example 9 | Comparative Example 2 | Comparative Example 3 |
|---|---|---|---|---|---|
| Vinyl resin | | (B)-8 | (B)-9 | (B)'-2 | (B)-4 |
| Functional group [X] | | Glycidyl group | Carboxylic anhydride group | None | Carboxyl group |
| Content of functional group [X] | Content of carboxyl group (mmol/kg) | 0 | 465 | 0 | 233 |
| | Content of functional group [X] other than carboxyl group (mmol/kg) | 282 | 0 | 0 | 0 |
| Fluid | | Fluid 1 | Fluid 1 | Fluid 1 | Fluid 2 |
| Adhesion | | A | A | D | D |
| Bending adhesion | | A | B | D | D |

**[Table 4]**

| Table 4 | | Example 10 | Example 11 | Example 12 | Example 13 |
|---|---|---|---|---|---|
| Urethane-acrylic composite resin | | (B)-10 | (B)-11 | (B)-12 | (B)-13 |
| Functional group [X] | | Carboxyl group | N-Methylolacrylamide group | Carboxyl group Keto group | Glycidyl group |
| Content of functional group [X] | Content of carboxyl group (mmol/kg) | 265 | 265 | 318 | 318 |
| | Content of functional group [X] other than carboxyl group (mmol/kg) | 0 | 396 | 296 | 141 |
| Fluid | | Fluid 1 | Fluid 1 | Fluid 1 | Fluid 1 |
| Adhesion | | B | A | A | A |
| Bending adhesion | | B | A | A | A |

The conductive pattern described in Example 1, in which a urethane resin was used as a resin forming a primer layer, had excellent adhesion between the conductive layer and the primer layer. The conductive patterns described in Examples 2 and 3 had good adhesion between the conductive layer and the primer layer.

The conductive patterns described in Examples 5, 6, and 8, in which an acrylic resin was used as a resin forming a primer layer, had excellent adhesion between the conductive layer and the primer layer. The conductive patterns described in Examples 4, 7, and 9 had good adhesion between the conductive layer and the primer layer.

The conductive patterns described in Examples 11 and 12, in which a urethane-acrylic resin was used as a resin forming a primer layer, had excellent adhesion between the conductive layer and the primer layer. The conductive patterns described in Examples 10 and 13 had good adhesion between the conductive layer and the primer layer.

In contrast, the conductive pattern described in Comparative Example 1, the conductive pattern including a primer layer containing a urethane resin that did not have a functional group [X], might cause a decrease in the adhesion between the conductive layer and the primer layer. The conductive pattern described in Comparative Example 2, the conductive pattern including a primer layer containing an acrylic resin that did not have a functional group [X], might cause a decrease in the adhesion between the conductive layer and the primer layer.

The conductive pattern described in Comparative Example 3, which was obtained by using the fluid 2 that did not contain a polyalkyleneimine, might cause a decrease in the adhesion between the conductive layer and the primer layer.

## Claims

1. A conductive pattern comprising a conductive layer (A) containing a compound (a1) having a basic nitrogen atom-containing group and a conductive substance (a2); a primer layer (B) containing a compound (b1) having a functional group [X]; and a substrate layer (C), the conductive layer (A), the primer layer (B), and the substrate layer (C) being stacked, wherein a bond is formed by reacting the basic nitrogen atom-containing group of the compound (a1) contained in the conductive layer (A) with the functional group [X] of the compound (b1) contained in the primer layer (B) .

2. The conductive pattern according to Claim 1, wherein the compound (a1) having the basic nitrogen atom-containing group is a polyalkyleneimine or a polyalkyleneimine having a polyoxyalkylene structure containing an oxyethylene unit.

3. The conductive pattern according to Claim 1, wherein the functional group [X] is at least one selected from the group consisting of a keto group, an epoxy group, an acid group, an N-alkylol group, and an isocyanate group.

4. The conductive pattern according to Claim 1, wherein the compound (b1) having the functional group [X] contains at least one selected from the group consisting of a urethane resin (X1) having the functional group [X], a vinyl resin (x2) having the functional group [X], and a urethanevinyl composite resin (x3) having the functional group [X].

5. The conductive pattern according to Claim 1 produced by applying a composition (b1-1) containing the compound (b1) having the functional group [X] onto a part of a surface or an entire surface of a substrate to form a coating film (b); applying a fluid (A1) containing the compound (a1) having the basic nitrogen atom-containing group and the conductive substance (a2) onto a part of a surface or an entire surface of the coating film (b); and conducting heating.

6. The conductive pattern according to Claim 1, further comprising a plating layer (D) stacked on a surface of the conductive layer (A).

7. An electric circuit comprising the conductive pattern according to any one of Claims 1 to 6.

8. An electromagnetic wave shield comprising the conductive pattern according to any one of Claims 1 to 6.

## Patentansprüche

1. Leiterbild, umfassend eine leitende Schicht (A), enthaltend eine Verbindung (a1) mit einer basisches-Stickstoffatom-enthaltenden Gruppe und eine leitfähige Substanz (a2); eine Primerschicht (B), enthaltend eine Verbindung (b1) mit einer funktionellen Gruppe [X]; und eine Substratschicht (C), wobei die leitfähige Schicht (A), die Primerschicht (B) und die Substratschicht (C) übereinandergeschichtet sind, wobei eine Bindung gebildet ist durch Umsetzen der basisches-Stickstoffatom-enthaltenden Gruppe der Verbindung (a1), die in der leitfähigen Schicht (A) enthalten ist, mit der funktionellen Gruppe [X] der Verbindung (b1), die in der Primerschicht (B) enthalten ist.

2. Leiterbild nach Anspruch 1, wobei die Verbindung (a1) mit der basisches-Stickstoffatom-enthaltenden Gruppe ein Polyalkylenimin oder ein Polyalkylenimin mit einer Polyoxyalkylenstruktur, enthaltend eine Oxyethyleneinheit, ist.

3. Leiterbild nach Anspruch 1, wobei die funktionelle Gruppe [X] mindestens eine ist, ausgewählt aus der Gruppe, bestehend aus einer Ketogruppe, einer Epoxygruppe, einer Säuregruppe, einer N-Alkylolgruppe und einer Isocyanatgruppe.

4. Leiterbild nach Anspruch 1, wobei die Verbindung (b1) mit der funktionellen Gruppen [X] enthält: mindestens eines, ausgewählt aus der Gruppe, bestehend aus einem Urethanharz (x1) mit der funktionellen Gruppe [X], einem Vinylharz (x2) mit der funktionellen Gruppe [X] und einem Urethan-Vinylkompositharz (x3) mit der funktionellen Gruppe [X].

5. Leiterbild nach Anspruch 1, hergestellt durch Aufbringen einer Zusammensetzung (b1-1), enthaltend die Verbindung (b1) mit der funktionellen Gruppe [X] auf einen Teil einer Oberfläche oder eine gesamte Oberfläche von einem Substrat, um einen Beschichtungsfilm (b) zu bilden; Aufbringen einer Flüssigkeit (A1), enthaltend die Verbindung (a1) mit der basisches-Stickstoffatom-enthaltenden Gruppe und die leitfähige Substanz (a2), auf einen Teil einer Oberfläche oder eine gesamte Oberfläche des Beschichtungsfilms (b); und Durchführen von Erhitzen.

6. Leiterbild nach Anspruch 1, des Weiteren umfassend eine Plattierungsschicht (D), die auf eine Oberfläche der leitfähigen Schicht (A) aufgeschichtet ist.

7. Elektrische Schaltung, umfassend das Leiterbild nach einem der Ansprüche 1 bis 6.

8. Abschirmung für elektromagnetische Wellen, umfassend das Leiterbild nach einem der Ansprüche 1 bis 6.

## Revendications

1. Impression conductrice comprenant une couche conductrice (A) contenant un composé (a1) ayant un groupe contenant un atome d'azote basique et une substance conductrice (a2); une couche d'amorce (B) contenant un composé (b1) ayant un groupe fonctionnel [X] ; et une couche de substrat (C), la couche conductrice (A), la couche d'amorce (B), et la couche de substrat (C) étant empilées, dans laquelle une liaison est formée en faisant réagir le groupe contenant un atome d'azote basique du composé (a1) contenu dans la couche conductrice (A) avec le groupe fonctionnel [X] du composé (b1) contenu dans la couche d'amorce (B).

2. Impression conductrice selon la revendication 1, dans laquelle le composé (a1) ayant un groupe contenant un atome d'azote basique est une polyalkylèneimine ou une polyalkylèneimine ayant une structure polyoxyalkylène contenant un motif oxyéthylène.

3. Impression conductrice selon la revendication 1, dans laquelle le groupe fonctionnel [X] est au moins un élément choisi dans le groupe consistant en un groupe céto, un groupe époxy, un groupe acide, un groupe N-alkylol, et un groupe isocyanate.

4. Impression conductrice selon la revendication 1, dans laquelle le composé (b1) ayant le groupe fonctionnel [X] contient au moins un élément choisi dans le groupe consistant en une résine uréthane (x1) ayant le groupe fonctionnel [X], une résine vinylique (x2) ayant le groupe fonctionnel [X], et une résine composite uréthane-vinyle (x3) ayant le groupe fonctionnel [X].

5. Impression conductrice selon la revendication 1 produite par l'application d'une composition (b1-1) contenant le composé (b1) ayant le groupe fonctionnel [X] sur une partie d'une surface ou une surface entière d'un substrat pour former un film de revêtement (b) ; l'application d'un fluide (A1) contenant le composé (a1) ayant le groupe contenant un atome d'azote basique et la substance conductrice (a2) sur une partie d'une surface ou une surface entière du film de revêtement (b) ; et la réalisation d'un chauffage.

6. Impression conductrice selon la revendication 1, comprenant en outre une couche de placage (D) empilée sur une surface de la couche conductrice (A).

7. Circuit électrique comprenant l'impression conductrice selon l'une quelconque des revendications 1 à 6.

8. Blindage contre les ondes électromagnétiques comprenant l'impression conductrice selon l'une quelconque des revendications 1 à 6.
